# EUROPEAN PATENT APPLICATION

(11) **EP 2 135 910 A1**
(43) Date of publication of application: **23.12.2009**
(21) Application number: 08722499.4
(22) Date of filing: 19.03.2008
(51) Int. Cl.: C09J 179/08, C08L 63/00, C09J 4/00, C09J 7/02, C09J 11/06, C09J 163/00, H01L 21/301, H01L 21/52

(54) **PHOTOSENSITIVE ADHESIVE COMPOSITION, FILM-LIKE ADHESIVE, ADHESIVE SHEET, ADHESIVE PATTERN, SEMICONDUCTOR WAFER WITH ADHESIVE LAYER, SEMICONDUCTOR DEVICE AND SEMICONDUCTOR DEVICE MANUFACTURING METHOD**

(30) Priority: 04.04.2007 JP 2007098356; 14.09.2007 JP 2007239909
(71) Applicant: Hitachi Chemical Company, Ltd., Tokyo 163-0449 (JP)
(72) Inventor: MITSUKURA, Kazuyuki, Tsukuba-shi Ibaraki 300-4247 (JP); KAWAMORI, Takashi, Tsukuba-shi Ibaraki 300-4247 (JP); MASUKO, Takashi, Tsukuba-shi Ibaraki 300-4247 (JP); KATOGI, Shigeki, Tsukuba-shi Ibaraki 300-4247 (JP)
(74) Representative: Jönsson, Hans-Peter
(86) International application number: PCT/JP2008/055124
(87) International publication number: WO 2008/123110

(57) **Abstract**

The photosensitive adhesive composition of the invention comprises (A) an alkali-soluble resin, (B) an epoxy resin, (C) a radiation-polymerizable compound and (D) a photoinitiator, wherein the (D) photoinitiator contains at least (D1) a photoinitiator that exhibits a function which promotes polymerization and/or curing reaction of the epoxy resin by exposure to radiation.

## Description

### Technical Field

The present invention relates to a photosensitive adhesive composition, a film-like adhesive, an adhesive sheet, an adhesive pattern, a semiconductor wafer with an adhesive layer, a semiconductor device and a semiconductor device manufacturing method.

### Background Art

Adhesives have conventionally been used in the manufacture of semiconductor devices such as semiconductor packages, for bonding between semiconductor elements and semiconductor element-mounting support substrates. From the viewpoint of reliability for semiconductor devices, such adhesives must exhibit heat resistance and humidity-resistant reliability in order to satisfactorily guarantee solder reflow resistance. Methods also exist for bonding by a step of attaching a film-like adhesive to a semiconductor wafer or the like, in which case low-temperature attachment properties are required to minimize thermal damage to adherends. Various forms of semiconductor packages have been proposed in recent years for increasing high performance and high function of electronic parts, and adhesives with pattern formability in addition to the properties mentioned above are in demand, depending on the functions, forms and methods for simplifying the assembly processes of semiconductor devices. It is known that adhesive patterns can be formed using photosensitive adhesives that have photosensitive functions. Photosensitivity is a function whereby sections irradiated with light are chemically altered to become insolubilized or solubilized in aqueous solutions or organic solvents. When a photosensitive adhesive exhibiting photosensitivity is used, it is exposed through a photomask and a pattern is formed with a developing solution, thus allowing a high definition adhesive pattern to be formed.

The materials used for photosensitive adhesives having such pattern-forming functions have hitherto been polyimide resin precursors (polyamide acids) or polyimide resin-based materials, in consideration of heat resistance (for example, see Patent documents 1-3).

[Patent document 1] Japanese Unexamined Patent Publication No. 2000-290501
[Patent document 2] Japanese Unexamined Patent Publication No. 2001-329233
[Patent document 3] Japanese Unexamined Patent Publication HEI No. 11-24257

### Disclosure of the Invention

### Problems to be Solved by the Invention

However, although such materials are superior in terms of heat resistance, they require high temperatures of 300°C and above during thermal cyclization/imidation when using polyamide acids and during working when using polyimide resins, and therefore the thermal damage on surrounding materials is significant while thermal stress also tends to occur.

It has been attempted, incidentally, to improve low-temperature workability and soldering heat resistance by combining and crosslinking thermosetting resins with adhesives comprising polyimide resins and the like. However, it has been difficult with such methods to simultaneously achieve high levels of both pattern formability with alkali developing solutions and low-temperature attachment properties onto adherends. Moreover, it has been difficult to achieve reheat contact bondability after pattern formation and sufficiently high adhesive force after curing with the conventional materials mentioned above. Furthermore, when a curing catalyst such as an imidazole derivative is added to a system that employs a thermoplastic resin with a hydrophilic substituent such as a carboxyl group or hydroxyl group for the purpose of imparting solubility in the alkali developing solution, in order to improve the adhesion or humidity resistance, problems such as vastly reduced pot life have been encountered.

It is an object of the present invention, which has been accomplished in light of the aforementioned problems of the prior art, to provide a photosensitive adhesive composition with excellent pattern formability, adhesion after pattern formation, heat resistance and humidity-resistant reliability after bonding, and excellent low-temperature attachment properties after being formed into a film, as well as a film-like adhesive, an adhesive sheet, an adhesive pattern, a semiconductor wafer with an adhesive layer, a semiconductor device and a semiconductor device manufacturing method, which employ the same.

### Means for Solving the Problems

In order to achieve the object stated above, the invention provides a photosensitive adhesive composition comprising (A) an alkali-soluble resin, (B) an epoxy resin, (C) a radiation-polymerizable compound and (D) a photoinitiator, wherein the (D) photoinitiator contains at least (D1) a photoinitiator that exhibits a function which promotes polymerization and/or curing reaction of the epoxy resin by exposure to radiation.

Here, "promotes polymerization of the epoxy resin" means that it causes reaction at a lower temperature or causes gelling in a shorter time, than the epoxy alone.

According to the photosensitive adhesive composition of the invention having the construction described above, it is possible to satisfy the requirements for pattern formability, curability at low temperature in a short period of time and adhesion after pattern formation, heat resistance and humidity-resistant reliability after adhesion, and low-temperature attachment properties when the composition is formed into a film. According to the invention it is also possible to realize a photosensitive adhesive composition exhibiting the effects mentioned above while also having excellent storage stability at room temperature, by combination of the aforementioned components (A), (B) and (C) as well as component (D) containing component (D1).

The (D1) photoinitiator in the photosensitive adhesive composition of the invention is preferably a compound that generates a base by exposure to radiation. This can further improve the high-temperature adhesion onto adherends and humidity-resistant reliability of the photosensitive adhesive composition. The reason for this is believed to be that the base generated from the compound acts efficiently as an epoxy resin curing catalyst, thus further increasing the crosslink density.

The photosensitive adhesive composition described above can efficiently react with the epoxy resin to further reduce the outgas during standing at high temperature.

Also, if the (A) alkali-soluble resin in the photosensitive adhesive composition contains a carboxyl and/or hydroxyl group as an alkali-soluble group, an increased content of such groups may potentially increase the moisture absorption coefficient after curing and reduce the adhesive force after moisture absorption. With the photosensitive adhesive composition described above, however, the presence of a compound that generates a base by exposure to radiation can reduce the carboxyl and/or hydroxyl groups that remain after reaction of the carboxyl and/or hydroxyl groups with the epoxy resin, and thus result in higher levels of humidity-resistant reliability, and also both adhesion and pattern formability.

The (D1) photoinitiator in the photosensitive adhesive composition of the invention is preferably a compound with an oxime ester and/or morpholine ring. This can further increase the thermal decomposition initiation temperature.

From the viewpoint of improving the pattern formability for the photosensitive adhesive composition of the invention, the molar absorption coefficient of the (D1) photoinitiator for light with a wavelength of 365 nm is preferably 1000 ml/g·cm or greater.

From the viewpoint of reducing outgas and improving the high-temperature adhesion for the photosensitive adhesive composition of the invention, the 5% weight reduction temperature of the (D1) photoinitiator is preferably 150°C or higher.

The 5% weight reduction temperature of the photoinitiator is the 5% weight reduction temperature as measured for the photoinitiator using a differential thermogravimetric simultaneous measurement apparatus (TG/DTA6300 by SII NanoTechnology Inc.) with a temperature-elevating rate of 10°C/min and under a nitrogen flow (400 ml/min).

If the photosensitive adhesive composition of the invention comprises the (D1) photoinitiator described above, it will be possible to satisfy the requirements for pattern formability, adhesion after pattern formation, heat resistance and humidity-resistant reliability after adhesion, and low-temperature attachment properties when the composition is formed into a film.

The present inventors conjecture that the reasons for the effects mentioned above include the fact that the composition has a long shelf life, less outgas is generated by heat treatment after bonding, and reaction due to the application and drying temperature can be sufficiently inhibited when the composition is formed into a film.

The (D1) photoinitiator in the photosensitive adhesive composition of the invention is also preferably a compound represented by structural formula (I-1) below and/or a compound represented by structural formula (I-2) below and/or a compound represented by structural formula (1-3) below.

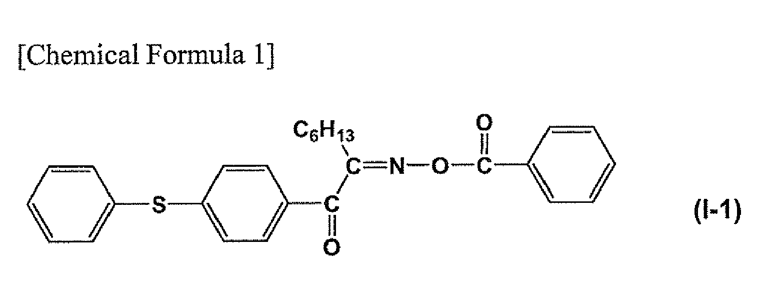

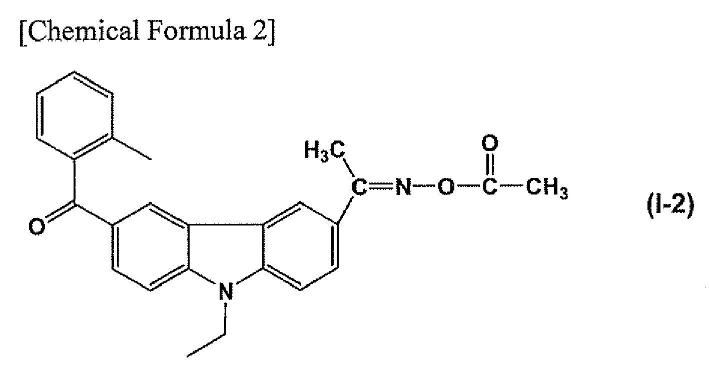

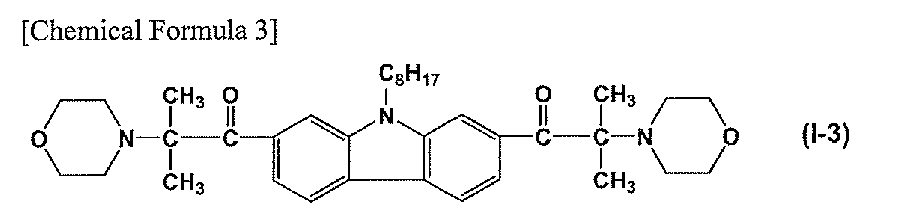

Furthermore, from the viewpoint of the low-temperature attachment property of the photosensitive adhesive composition of the invention, the glass transition temperature of the (A) alkali-soluble resin is preferably no higher than 150°C.

The (A) alkali-soluble resin in the photosensitive adhesive composition of the invention is preferably a resin with a carboxyl and/or hydroxyl group.

Normally, a higher content of such groups can potentially result in an increased moisture absorption coefficient after curing and reduced adhesive force after moisture absorption. With the photosensitive adhesive composition according to the invention as described above, however, the presence of component (D1) can reduce the carboxyl and/or hydroxyl groups that remain after reaction of the carboxyl and/or hydroxyl groups with the epoxy resin, and thus result in higher levels of humidity-resistant reliability, and also both adhesion and pattern formability.

The (A) alkali-soluble resin in the photosensitive adhesive composition of the invention is preferably a polyimide resin. This can further improve the pattern formability.

Also, the polyimide resin is preferably a polyimide resin obtained by reaction between a tetracarboxylic dianhydride and a diamine with a carboxyl and/or hydroxyl group in the molecule.

The polyimide resin is also preferably a polyimide resin obtained by reaction between a tetracarboxylic dianhydride and an aromatic diamine represented by structural formula (3) below and/or an aromatic diamine represented by structural formula (4) below.

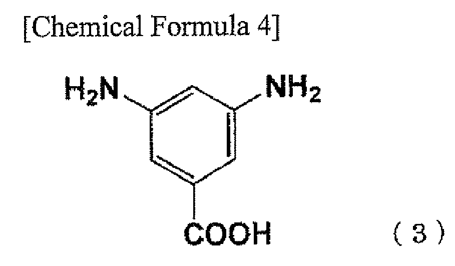

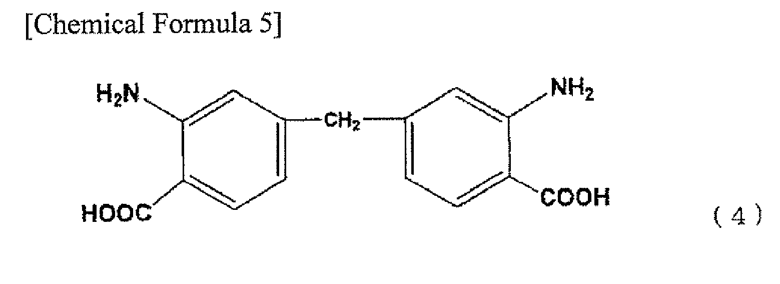

The invention further provides a film-like adhesive obtained by shaping the photosensitive adhesive composition of the invention into a film.

According to the film-like adhesive of the invention, which is composed of a photosensitive adhesive composition according to the invention, it is possible to satisfy all of the requirements for pattern formability, adhesion after pattern formation, heat resistance and humidity-resistant reliability after adhesion, and low-temperature attachment properties, while also increasing the efficiency of the semiconductor device assembly process and improving semiconductor device reliability.

The invention still further provides an adhesive sheet comprising a base and an adhesive layer composed of a photosensitive adhesive composition according to the invention as described above, formed on one side of the base.

According to the adhesive sheet of the invention, which comprises an adhesive layer composed of a photosensitive adhesive composition according to the invention, it is possible to satisfy all of the requirements for pattern formability, adhesion after pattern formation, heat resistance and humidity-resistant reliability after adhesion, and low-temperature attachment properties, while also increasing the efficiency of the semiconductor device assembly process improving and semiconductor device reliability.

The invention still further provides an adhesive sheet having a laminated structure obtained by laminating a film-like adhesive according to the invention with a dicing sheet.

Such an adhesive sheet having the structure described above can be used to realize a die bonding/dicing sheet that satisfies the requirements for pattern formability, curability at low temperature in a short period of time after pattern formation, adhesion, heat resistance and humidity-resistant reliability after adhesion, as well as low-temperature attachment properties. This will make it possible to achieve increased efficiency for the semiconductor device assembly process and improved reliability for semiconductor devices.

The invention still further provides an adhesive pattern that is formed by forming an adhesive layer composed of a photosensitive adhesive composition of the invention on an adherend, exposing the adhesive layer to light through a photomask, and developing the exposed adhesive layer with an alkali developing solution.

The adhesive pattern of the invention which is formed of a photosensitive adhesive composition according to the invention allows high definition to be achieved with excellent adhesion, while also obtaining excellent heat resistance and humidity-resistant reliability after adhesion.

The invention still further provides a semiconductor wafer with an adhesive layer, that comprises a semiconductor wafer and an adhesive layer composed of a photosensitive adhesive composition according to the invention as described above, formed on one side of the semiconductor wafer.

A semiconductor wafer with an adhesive layer of the invention, which comprises an adhesive layer composed of a photosensitive adhesive composition according to the invention, allows pattern formation of the adhesive layer while also exhibiting excellent adhesion after pattern formation and heat resistance and humidity-resistant reliability after adhesion, and can therefore increase the efficiency of the semiconductor device assembly process and improve semiconductor device reliability.

The invention still further provides a semiconductor device wherein a semiconductor element and a semiconductor element-mounting supporting member are bonded by a photosensitive adhesive composition according to the invention.

Since the semiconductor device of the invention comprises a semiconductor element and a semiconductor element-mounting supporting member bonded by a photosensitive adhesive composition according to the invention which has excellent pattern formability, adhesion after pattern formation, and heat resistance (high-temperature adhesion) and humidity-resistant reliability after adhesion, it can sufficiently simplify the production process while also exhibiting excellent reliability.

The invention still further provides a semiconductor device manufacturing method comprising a step of bonding a semiconductor element and a semiconductor element-mounting supporting member using a photosensitive adhesive composition according to the invention.

According to the semiconductor device manufacturing method of the invention which employs a photosensitive adhesive composition of the invention, it is possible to provide semiconductor devices with excellent reliability. In addition, the semiconductor device manufacturing method of the invention allows reliable production of semiconductor devices with various functions and shapes to be accomplished.

### Effect of the Invention

According to the invention it is possible to provide a photosensitive adhesive composition with excellent pattern formability, adhesion after pattern formation, heat resistance and humidity-resistant reliability after bonding, and excellent low-temperature attachment properties after being formed into a film, as well as a film-like adhesive, an adhesive sheet, an adhesive pattern, a semiconductor wafer with an adhesive layer, a semiconductor device and a semiconductor device manufacturing method, which employ the same.

### Brief Description of the Drawings

Fig. 1 is a schematic cross-sectional view showing an embodiment of a film-like adhesive according to the invention.
Fig. 2 is a schematic cross-sectional view showing an embodiment of an adhesive sheet according to the invention.
Fig. 3 is a schematic cross-sectional view showing another embodiment of an adhesive sheet of the invention.
Fig. 4 is a schematic cross-sectional view showing another embodiment of an adhesive sheet of the invention.
Fig. 5 is a top view showing an embodiment of a semiconductor wafer with an adhesive layer according to the invention.
Fig. 6 is an end view of Fig. 5 along line IV-IV.
Fig. 7 is a top view showing an embodiment of an adhesive pattern according to the invention.
Fig. 8 is an end view of Fig. 7 along line V-V.
Fig. 9 is a top view showing an embodiment of an adhesive pattern according to the invention.
Fig. 10 is an end view of Fig. 9 along line VI-VI.
Fig. 11 is a schematic cross-sectional view showing an embodiment of a semiconductor device according to the invention.
Fig. 12 is a schematic cross-sectional view showing another embodiment of a semiconductor device according to the invention.
Fig. 13 is a schematic diagram of a peel strength tester.

### Best Mode for Carrying Out the Invention

Preferred embodiments of the invention will now be explained in detail, with reference to the accompanying drawings as necessary. Identical or corresponding parts in the drawings will be referred to by like reference numerals and will be explained only once. Unless otherwise specified, the vertical and horizontal positional relationships are based on the positional relationships in the drawings. Also, the dimensional proportions depicted in the drawings are not necessarily limitative.

The photosensitive adhesive composition of the invention is a photosensitive adhesive composition comprising (A) an alkali-soluble resin, (B) an epoxy resin, (C) a radiation-polymerizable compound and (D) a photoinitiator, wherein the (D) photoinitiator contains at least (D1) a photoinitiator that exhibits a function which promotes polymerization and/or curing reaction of the (B) epoxy resin by exposure to radiation.

The (A) alkali-soluble resin in the photosensitive adhesive composition of the invention may be a thermoplastic resin with an alkali-soluble group, and specifically a carboxyl and/or hydroxyl group. As examples of such thermoplastic resins there may be mentioned polyimide resins, polyamide resins, polyamideimide resins, polyetherimide resins, polyurethaneimide resins, polyurethaneamideimide resins, siloxanepolyimide resins, polyesterimide resins, and their copolymers and precursors (polyamide acids), as well as phenoxy resins, polysulfone resins, polybenzooxazoles, polyethersulfone resins, phenol-novolac resins, cresol-novolac resins, polyphenylene sulfide resins, polyester resins, polyetherketone resins, and (meth)acrylic copolymers with weight-average molecular weights of 10,000-1000,000. Any of these may be used alone or in combinations of two or more. If necessary, the aforementioned resins without alkali-soluble groups may also be added.

Preferred for the (A) alkali-soluble resin are resins with carboxyl groups, from the viewpoint of obtaining satisfactory developing properties. The (A) alkali-soluble resin is preferably a resin having an alkali-soluble group on an end or side chain. When the alkali-soluble group is a hydroxyl group, it is preferably a phenolic hydroxyl group.

The attachment temperature for the film-like adhesive of the invention onto a wafer back side is preferably 20-200°C, more preferably 20-150°C and most preferably 25-100°C, from the viewpoint of inhibiting warping of the semiconductor wafer. In order to allow attachment in this temperature range, the Tg of the film-like adhesive is preferably no higher than 150°C. The glass transition temperature (Tg) of the (A) alkali-soluble resin used in the photosensitive adhesive composition is therefore preferably no higher than 150°C, more preferably between -20 and 100°C and most preferably between -20 and 80°C. If the Tg of the (A) alkali-soluble resin is higher than 150°C, the attachment temperature onto wafer back sides may increase above 200°C and warping of wafer back sides will tend to occur more easily, while if the Tg is below -20°C the tack property of the film surface in the B-stage state will be too strong, tending to impair the manageability. The composition of the polyimide resin described hereunder is preferably designed so that the Tg is no higher than 150°C.

The weight-average molecular weight of the (A) alkali-soluble resin is preferably limited to within the range of 10,000-300,000, more preferably 10,000-100,000 and even more preferably 10,000-80,000. If the weight-average molecular weight is within this range, the strength, pliability and tack properties of the photosensitive adhesive composition formed into a sheet or film will be satisfactory, while the hot flow property will also be satisfactory, thus helping to ensure good embedding properties in wiring steps on the board surface. If the weight-average molecular weight is less than 10,000 the film formability will tend to be impaired, while if it is greater than 300,000 the hot flow property will be poor, the embedding property into irregularities on the board will tend to be reduced, and the solubility of the (A) alkali-soluble resin in the alkali developing solution will tend to be lower.

If the Tg and weight-average molecular weight of the (A) alkali-soluble resin are within these ranges, it will be possible to lower the attachment temperature onto wafer back sides while also lowering the heating temperature for adhesive anchoring of the semiconductor element to the semiconductor element-mounting supporting member (die bonding temperature) and limit increase in warping of the semiconductor element. It will also be possible to effectively impart a flow property and developing property for die bonding, as a feature of the invention.

The Tg is the primary dispersion peak temperature when the (A) alkali-soluble resin is formed into a film, and the primary dispersion temperature is obtained by measurement of the tanδ peak temperature near Tg using an "RSA-2" viscoelasticity analyzer (trade name) by Rheometrix, under conditions with a temperature-elevating rate of 5°C/min, a frequency of 1 Hz and a measuring temperature of between - 150 and 300°C. The weight-average molecular weight is the weight-average molecular weight measured in terms of polystyrene using a "C-R4A" high-performance liquid chromatograph (trade name) by Shimadzu Corp.

The (A) alkali-soluble resin is preferably a polyimide resin from the viewpoint of heat resistance and adhesion. The polyimide resin may be obtained, for example, by condensation reaction of a tetracarboxylic dianhydride and diamine by a known process. Specifically, the compositional ratio is adjusted so that the tetracarboxylic dianhydride and diamine are in equimolar amounts in the organic solvent, or if necessary so that the total of diamines is in the range of preferably 0.5-2.0 mol and more preferably 0.8-1.0 mol with respect to 1.0 mol as the total tetracarboxylic dianhydrides (with any desired order of addition of the components), and addition reaction is conducted with a reaction temperature of no higher than 80°C and preferably 0-60°C. The viscosity of the reaction mixture will gradually increase as the reaction proceeds, forming polyamide acid as the polyimide resin precursor. In order to prevent reduction in the properties of the adhesive composition, the tetracarboxylic dianhydride is preferably one that has been subjected to recrystallizing purifying treatment with acetic anhydride.

If total diamines exceed 2.0 mol with respect to 1.0 mol as the total tetracarboxylic dianhydrides, in the compositional ratio of the tetracarboxylic dianhydride and diamine components for the condensation reaction, the amount of amine-terminal polyimide oligomers in the obtained polyimide resin will tend to be greater and the weight-average molecular weight of the polyimide resin will be reduced, thus tending to lower the properties of the adhesive composition, including the heat resistance. On the other hand, a total diamine content of less than 0.5 mol will tend to result in more acid-terminal polyimide oligomers and a lower weight-average molecular weight of the polyimide resin, which will tend to lower the properties of the adhesive composition including the heat resistance.

The charging compositional ratio for the tetracarboxylic dianhydrides and diamines is preferably determined as appropriate so that the weight-average molecular weight of the obtained polyimide resin is 10,000-300,000.

The polyimide resin may be obtained by dehydrating cyclization of the reaction product (polyamide acid). Dehydrating cyclization can be accomplished by thermal cyclization using heat treatment or by chemical cyclization using a dehydrating agent.

There are no particular restrictions on the tetracarboxylic dianhydride used as the starting material for the polyimide resin, and as examples there may be mentioned pyromellitic acid dianhydride, 3,3',4,4'-biphenyltetracarboxylic dianhydride, 2,2',3,3'-biphenyltetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylenetetracarboxylic dianhydride, bis(3,4-dicarboxyphenyl)ether dianhydride, benzene-1,2,3,4-tetracarboxylic dianhydride, 3,4,3',4'-benzophenonetetracarboxylic dianhydride, 2,3,2',3'-benzophenonetetracarboxylic dianhydride, 3,3,3',4'-benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,4,5-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,5,6-tetracarboxylic dianhydride, 2,3,3',4'-biphenyltetracarboxylic dianhydride, 3,4,3',4'-biphenyltetracarboxylic dianhydride, 2,3,2',3'-biphenyltetracarboxylic dianhydride, bis(3,4-dicarboxyphenyl)dimethylsilane dianhydride, bis(3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, p-phenylenebis(trimellitate anhydride), ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetracarboxylic dianhydride, bis(exo-bicyclo[2,2,1]heptane-2,3-dicarboxylic dianhydride, bicyclo-[2,2,2]-oct-7-ene-2,3,5,6-tetracarboxylic dianhydride, 2,2-bis(3,4-dicarboxyphenyl)propane dianhydride, 2,2-bis[4-(3,4-dicarboxyphenyl)phenyl]propane dianhydride, 2,2-bis(3,4-dicarboxyphenyl)hexafluoropropane dianhydride, 2,2-bis[4-(3,4-dicarboxyphenyl)phenyl]hexafluoropropane dianhydride, 4,4'-bis(3,4-dicarboxyphenoxy)diphenyl sulfide dianhydride, 1,4-bis(2-hydroxyhexafluoroisopropyl)benzenebis(trimellitic anhydride), 1,3-bis(2-hydroxyhexafluoroisopropyl)benzenebis(trimellitic anhydride), 5-(2,5-dioxotetrahydrofuryl)-3-methyl-3-cyclohexene-1,2-dicarboxylic dianhydride, tetrahydrofuran-2,3,4,5-tetracarboxylic dianhydride, and tetracarboxylic dianhydrides represented by the following general formula (5).

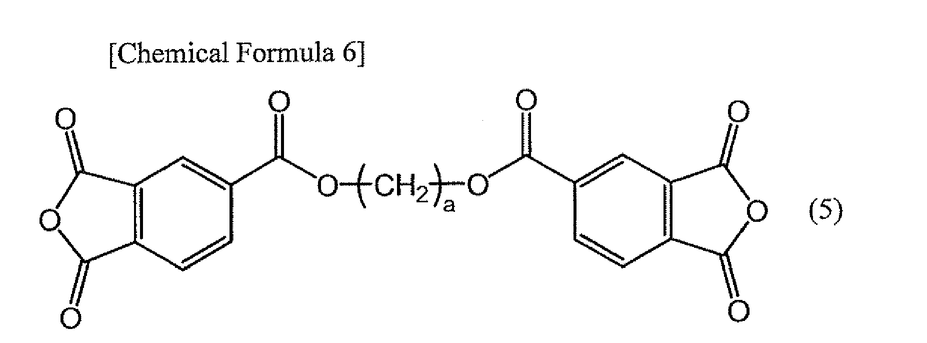

[In the formula, a represents an integer of 2-20.]

The tetracarboxylic dianhydrides represented by general formula (5) above can be synthesized, for example, from anhydrous trimellitic monochloride and the corresponding diol, and specifically there may be mentioned 1,2-(ethylene)bis(trimellitate anhydride), 1,3-(trimethylene)bis(trimellitate anhydride), 1,4-(tetramethylene)bis(trimellitate anhydride), 1,5-(pentamethylene)bis(trimellitate anhydride), 1,6-(hexamethylene)bis(trimellitate anhydride), 1,7-(heptamethylene)bis(trimellitate anhydride), 1,8-(octamethylene)bis(trimellitate anhydride), 1,9-(nonamethylene)bis(trimellitate anhydride), 1,10-(decamethylene)bis(trimellitate anhydride), 1,12-(dodecamethylene)bis(trimellitate anhydride), 1,16-(hexadecamethylene)bis(trimellitate anhydride) and 1,18-(octadecamethylene)bis(trimellitate anhydride).

As tetracarboxylic dianhydrides there are preferred tetracarboxylic dianhydrides represented by the following formula (6) or (7), from the viewpoint of imparting satisfactory solubility in the solvent and satisfactory humidity-resistant reliability.

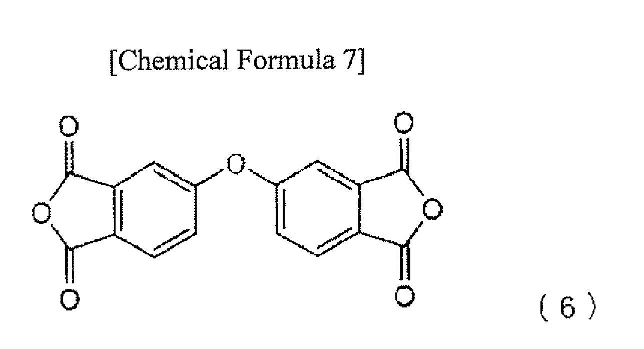

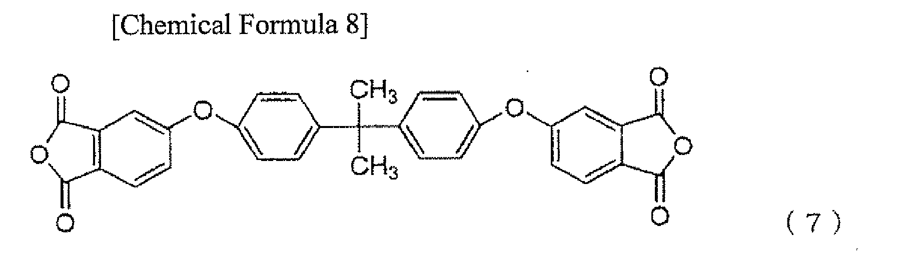

These tetracarboxylic dianhydrides may be used alone or in combinations of two or more.

The diamines used as starting materials for the polyimide resin preferably include an aromatic diamine represented by the following formula (8), (9), (10) or (11). The diamines represented by the following formulas (8)-(11) preferably constitute 1-50 mol% of the total diamines. It will thus be possible to prepare a polyimide resin that is soluble in the alkali developing solution.

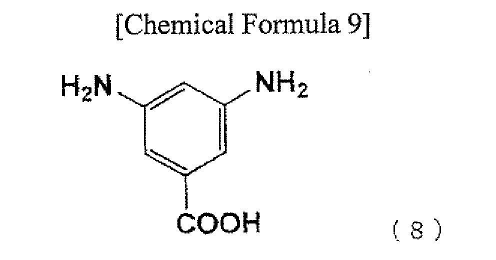

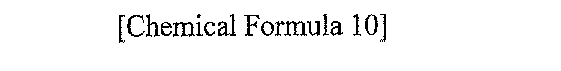

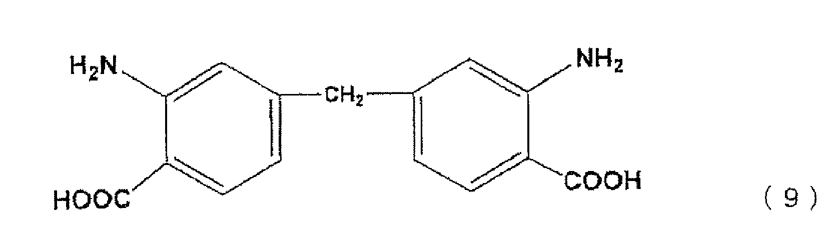

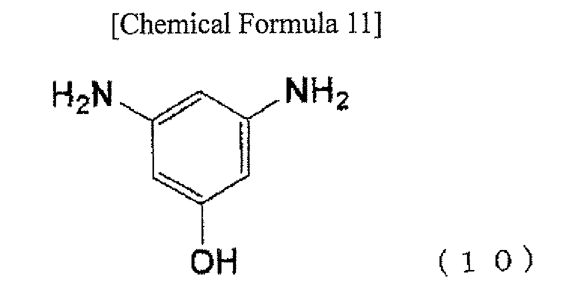

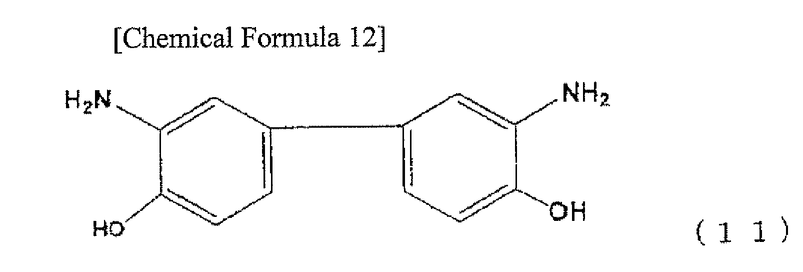

There are no particular restrictions on other diamines to be used as starting materials for the polyimide resin, and as examples there may be mentioned aromatic diamines such as o-phenylenediamine, m-phenylenediamine, p-phenylenediamine, 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylethermethane, bis(4-amino-3,5-dimethylphenyl)methane, bis(4-amino-3,5-diisopropylphenyl)methane, 3,3'-diaminodiphenyldifluoromethane, 3,4'-diaminodiphenyldifluoromethane, 4,4'-diaminodiphenyldifluoromethane, 3,3'-diaminodiphenylsulfone, 3,4'-diaminodiphenylsulfone, 4,4'-diaminodiphenylsulfone, 3,3'-diaminodiphenyl sulfide, 3,4'-diaminodiphenyl sulfide, 4,4'-diaminodiphenyl sulfide, 3,3'-diaminodiphenylketone, 3,4'-diaminodiphenylketone, 4,4'-diaminodiphenylketone, 2,2-bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3-bis(3-aminophenoxy)benzene, 1,4-bis(3-aminophenoxy)benzene, 1,4-bis(4-aminophenoxy)benzene, 3,3'-(1,4-phenylenebis(1-methylethylidene))bisaniline, 3,4'-(1,4-phenylenebis(1-methylethylidene))bisaniline, 4,4'-(1,4-phenylenebis(1-methylethylidene))bisaniline, 2,2-bis(4-(3-aminophenoxy)phenyl)propane, 2,2-bis(4-(3-aminophenoxy)phenyl)hexafluoropropane, 2,2-bis(4-(4-aminophenoxy)phenyl)hexafluoropropane, bis(4-(3-aminoenoxy)phenyl)sulfide, bis(4-(4-aminoenoxy)phenyl)sulfide, bis(4-(3-aminoenoxy)phenyl)sulfone, bis(4-(4-aminoenoxy)phenyl)sulfone, 3,3'-dihydroxy-4,4'-diaminobiphenyl and 3,5-diaminobenzoic acid, and 1,3-bis(aminomethyl)cyclohexane, 2,2-bis(4-aminophenoxyphenyl)propane, aliphatic etherdiamines represented by general formula (12) below, aliphatic diamines represented by general formula (13) below and siloxanediamines represented by general formula (14) below.

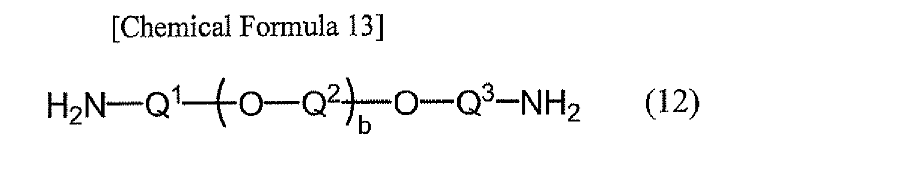

[In the formula, Q¹, Q² and Q³ each independently represent a C₁₋₁₀ alkylene group, and b represents an integer of 2-80.]

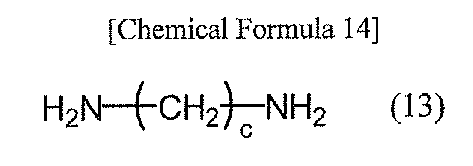

[In the formula, c represents an integer of 5-20.]

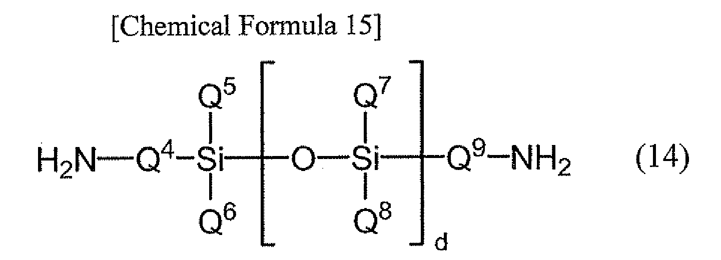

[In the formula, Q⁴ and Q⁹ each independently represent a C1-5 alkylene or optionally substituted phenylene group, Q⁵, Q⁶, Q⁷ and Q⁸ each independently represent a C1-5 alkyl, phenyl or phenoxy group, and d represents an integer of 1-5.]

As specific aliphatic etherdiamines represented by general formula (12) above there may be mentioned aliphatic diamines represented by the following formula: 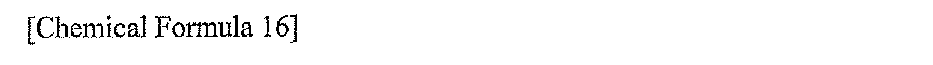 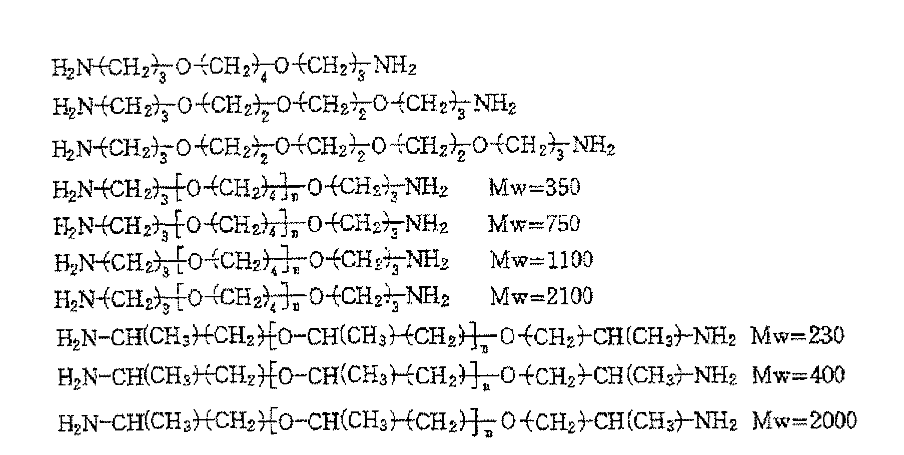 and aliphatic etherdiamines represented by the following formula (15).

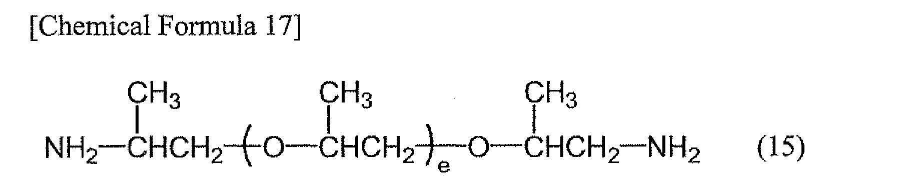

[In the formula, e represents an integer of 0-80.]

As specific aliphatic diamines represented by general formula (13) above there may be mentioned 1,2-diaminoethane, 1,3-diaminopropane, 1,4-diaminobutane, 1,5-diaminopentane, 1,6-diaminohexane, 1,7-diaminoheptane, 1,8-diaminooctane, 1,9-diaminononane, 1,10-diaminodecane, 1,11-diaminoundecane, 1,12-diaminododecane and 1,2-diaminocyclohexane.

As specific siloxanediamines represented by general formula (14) above, where d in formula (14) is 1, there may be mentioned 1,1,3,3-tetramethyl-1,3-bis(4-aminophenyl)disiloxane, 1,1,3,3-tetraphenoxy-1,3-bis(4-aminoethyl)disiloxane, 1,1,3,3-tetraphenyl-1,3-bis(2-aminoethyl)disiloxane, 1,1,3,3-tetraphenyl-1,3-bis(3-aminopropyl)disiloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(3-aminobutyl)disiloxane and 1,3-dimethyl-1,3-dimethoxy-1,3-bis(4-aminobutyl)disiloxane, and where d is 2 there may be mentioned 1,1,3,3,5,5-hexamethyl-1,5-bis(4-aminophenyl)trisiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisiloxane, 1,1,5,5-tetramethyl-3,3-dimethoxy-1,5-bis(2-aminoethyl)trisiloxane, 1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3,3,5,5-hexaethyl-1,5-bis(3-aminopropyl)trisiloxane and 1,1,3,3,5,5-hexapropyl-1,5-bis(3-aminopropyl)trisiloxane.

These diamines may be used alone or in combinations of two or more.

The above-mentioned polyimide resins may be used alone, or if necessary they may be used as mixtures (blends) of two or more different types.

As mentioned above, the composition of the polyimide resin is preferably designed so that the Tg is no higher than 150°C, and the diamine used as a starting material for the polyimide resin is preferably an aliphatic etherdiamine represented by general formula (15) above. As specific aliphatic etherdiamines represented by general formula (15) there may be mentioned aliphatic diamines including polyoxyalkylenediamines such as JEFFAMINE D-230, D-400, D-2000, D-4000, ED-600, ED-900, ED-2000 and EDR-148 by San Techno Chemical Co., Ltd., and polyetheramine D-230, D-400 and D-2000 by BASF. These diamines constitute preferably 1-80 mol% and more preferably 5-60 mol% of the total diamines. If the amount is less than 1 mol% it will tend to be difficult to impart low-temperature adhesion and a hot flow property, while if it is greater than 80 mol% the Tg of the polyimide resin will be too low, tending to impair the autosupporting property of the film.

The polyimide resin can be obtained by reacting a tetracarboxylic dianhydride with a diamine having carboxyl and amino groups, so that the carboxyl groups of the diamine are introduced into the polyimide. When a polyimide resin is used as the (A) alkali-soluble resin, it is particularly preferred to appropriately adjust the type of diamine, the charging ratio and the reaction conditions to obtain a polyimide resin with a Tg of no higher than 150°C and an Mw of 5,000-150,000.

From the viewpoint of pattern formability and adhesion, the content of component (A) in the photosensitive adhesive composition of the invention is preferably 5-90 wt% and more preferably 20-80 wt% based on the total solid weight of the photosensitive adhesive composition. If the content is less than 20 wt% the pattern formability will tend to be impaired, while if it is greater than 80 wt% the pattern formability and adhesion will tend to be reduced.

The (B) epoxy resin used for the invention preferably contains at least two epoxy groups in the molecule, and more preferably it is a phenol glycidyl ether-type epoxy resin, from the viewpoint of curability and cured properties. As examples of such resins there may be mentioned bisphenol A (or AD, S, F)-type glycidyl ether, hydrogenated bisphenol A-type glycidyl ether, ethylene oxide adduct bisphenol A-type glycidyl ether, propylene oxide adduct-bisphenol A-type glycidyl ether, phenol-novolac resin glycidyl ether, cresol-novolac resin glycidyl ether, bisphenol A-novolac resin glycidyl ether and naphthalene resin glycidyl ether, trifunctional (or tetrafunctional) glycidyl ethers, dicyclopentadienephenol resin glycidyl ethers, dimer acid glycidyl esters, trifunctional (or tetrafunctional) glycidylamines, naphthalene resin glycidylamines, and the like. These may be used alone or in combinations of two or more.

From the viewpoint of preventing electromigration and corrosion of metal conductor circuits, the (B) epoxy resin is preferably a high purity product with a content of no greater than 300 ppm for impurity ions such as alkali metal ions, alkaline earth metal ions and halide ions, and particularly chlorine ions or hydrolyzable chlorine.

The content of component (B) in the photosensitive adhesive composition of the invention is preferably 0.1-200 parts by weight and more preferably 2-50 parts by weight with respect to 100 parts by weight of component (A). A content of greater than 200 parts by weight will tend to lower the solubility in the aqueous alkali solution and reduce the pattern formability. On the other hand, a content of less than 2 parts by weight will tend to lower the high-temperature adhesion.

The photosensitive adhesive composition of the invention may also contain an epoxy resin curing agent if necessary. As examples of curing agents there may be mentioned phenol-based compounds, aliphatic amines, alicyclic amines, aromatic polyamines, polyamides, aliphatic acid anhydrides, alicyclic acid anhydrides, aromatic acid anhydrides, dicyandiamides, organic acid dihydrazides, boron trifluoride amine complexes, imidazoles and tertiary amines. Phenol-based compounds are preferred among these, with phenol-based compounds having two or more phenolic hydroxyl groups in the molecule being more preferred. As examples of such compounds there may be mentioned phenol-novolac, cresol-novolac, t-butylphenol-novolac, dicyclopentadienecresol-novolac, dicyclopentadienephenol-novolac, xylylene-modified phenol-novolac, naphthol-based compounds, trisphenol-based compounds, tetrakisphenol-novolac, bisphenol A-novolac, poly-p-vinylphenol and phenolaralkyl resins. Compounds with a number-average molecular weight in the range of 400-1500 are preferred among these. This will help minimize outgas during heating, which can cause contamination of the semiconductor element or apparatus during the heating for semiconductor device assembly.

The photosensitive adhesive composition of the invention may also contain a curing accelerator if necessary. The curing accelerator is not particularly restricted so long as it cures the epoxy resin, and as examples there may be mentioned imidazoles, dicyandiamide derivatives, dicarboxylic acid dihydrazides, triphenylphosphine, tetraphenylphosphoniumtetraphenyl borate, 2-ethyl-4-methylimidazole-tetraphenyl borate, 1,8-diazabicyclo[5.4.0]undecene-7-tetraphenyl borate, and urethane-based base generators that produce bases upon heating. The content of the curing accelerator in the photosensitive adhesive composition is preferably 0.01-50 parts by weight with respect to 100 parts by weight of the epoxy resin.

The (C) radiation-polymerizable compound in the photosensitive adhesive composition of the invention is not particularly restricted so long as it is a compound that polymerizes and/or cures by exposure to radiation such as ultraviolet rays or an electron beam. As specific examples of radiation-polymerizable compounds there may be mentioned methyl acrylate, methyl methacrylate, ethyl acrylate, ethyl methacrylate, butyl acrylate, butyl methacrylate, 2-ethylhexyl acrylate, 2-ethylhexyl methacrylate, pentenyl acrylate, tetrahydrofurfuryl acrylate, tetrahydrofurfuryl methacrylate, diethyleneglycol diacrylate, triethyleneglycol diacrylate, tetraethyleneglycol diacrylate, diethyleneglycol dimethacrylate, triethyleneglycol dimethacrylate, tetraethyleneglycol dimethacrylate, trimethylolpropane diacrylate, trimethylolpropane triacrylate, trimethylolpropane dimethacrylate, trimethylolpropane trimethacrylate, 1,4-butanediol diacrylate, 1,6-hexanediol diacrylate, 1,4-butanediol dimethacrylate, 1,6-hexanediol dimethacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, styrene, divinylbenzene, 4-vinyltoluene, 4-vinylpyridine, N-vinylpyrrolidone, 2-hydroxyethyl acrylate, 2-hydroxyethyl methacrylate, 1,3-acryloyloxy-2-hydroxypropane, 1,2-methacryloyloxy-2-hydroxypropane, methylenebisacrylamide, N,N-dimethylacrylamide, N-methylolacrylamide, diacrylates of tris(β-hydroxyethyl)isocyanurate, triacrylates of tris(β-hydroxyethyl)isocyanurate, compounds represented by general formula (16) below, epoxy acrylates, urethane acrylates, urethane methacrylates and urea acrylates.

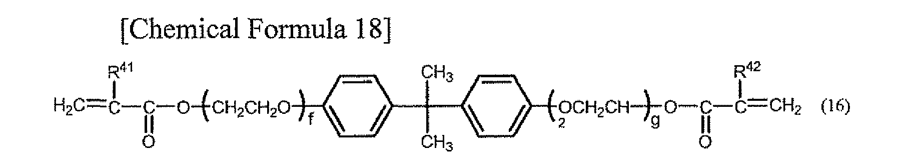

[In the formula, R⁴¹ and R⁴² each independently represent hydrogen or a methyl group, and f and g each independently an integer of 1 or greater.]

The aforementioned urethane acrylates and urethane methacrylates are produced, for example, by reaction of diols, isocyanate compounds represented by general formula (17) below and compounds represented by general formula (18) below.

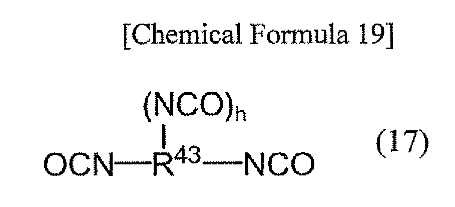

[In the formula, R⁴³ represents a C1-30 divalent or trivalent organic group, and h represents 0 or 1.]

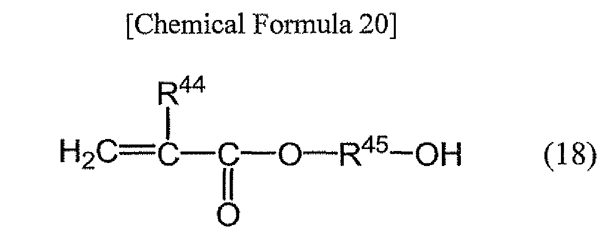

[In the formula, R⁴⁴ represents hydrogen or a methyl group, and R⁴⁵ represents an ethylene or propylene group.]

The aforementioned urea methacrylates are produced, for example, by reaction of a diamine represented by general formula (19) below and a compound represented by general formula (20) below.

[Chemical Formula 21] H₂N-R⁴⁶-NH₂ (19)

[In the formula, R⁴⁶ represents a C2-30 divalent organic group.]

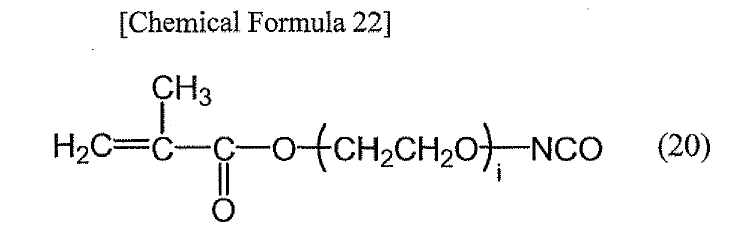

[In the formula, i represents 0 or 1.]

In addition to these compounds, there may be used radiation-polymerizable copolymers having ethylenic unsaturated groups on side chains, which are obtained by addition reaction of a compound having at least one ethylenic unsaturated group and a functional group such as an oxirane ring or an isocyanate, hydroxyl or carboxyl group, with a functional group-containing vinyl copolymer.

These radiation-polymerizable compounds may be used alone or in combinations of two or more. Among them, radiation polymerizing compounds represented by general formula (16) above are preferred from the standpoint of imparting sufficient solvent resistance after curing, and urethane acrylates, urethane methacrylates and isocyanuric acid-modified acrylates are preferred from the standpoint of imparting sufficient high adhesion after curing.

The content of component (C) in the photosensitive adhesive composition of the invention is preferably 20-200 parts by weight and more preferably 30-100 parts by weight with respect to 100 parts by weight of component (A). A content of greater than 200 parts by weight will tend to lower the flow property during heat-fusion due to polymerization, thus reducing the adhesion during thermocompression bonding. On the other hand, a content of less than 5 parts by weight will tend to lower the solvent resistance after the photocuring by exposure, thus interfering with formation of the pattern.

As an example for the (D1) photoinitiator that exhibits a function of promoting polymerization and/or curing reaction of the epoxy resin by exposure to radiation, which is present in the photosensitive adhesive composition of the invention, there may be mentioned photobase generators that generate bases by irradiation, and photoacid generators that generate acids by irradiation.

A photobase generator is preferably used as component (D1) in the photosensitive adhesive composition of the invention. This can further improve the high-temperature adhesion onto adherends and humidity-resistant reliability of the photosensitive adhesive composition. The reason for this is believed to be that the base generated from the compound acts efficiently as an epoxy resin curing catalyst, thus further increasing the crosslink density.

By including a photobase generator in the photosensitive adhesive composition, it is possible to improve the crosslink density and further reduce the outgas during standing at high temperature.

Also, if the (A) alkali-soluble resin in the photosensitive adhesive composition contains a carboxyl and/or hydroxyl group as an alkali-soluble group, an increased content of such groups may potentially increase the moisture absorption coefficient after curing and reduce the adhesive force after moisture absorption. With the photosensitive adhesive composition described above, however, the presence of a compound that generates a base by exposure to radiation can reduce the carboxyl and/or hydroxyl groups that remain after reaction of the carboxyl and/or hydroxyl groups with the epoxy resin, and thus result in higher levels of humidity-resistant reliability, and also both adhesion and pattern formability.

Any photobase generator that is a compound that generates bases upon irradiation may be used, without any particular restrictions. Using the pKa value which is the logarithm of the acid dissociation constant generally used as the index of the basicity, the base that is generated is preferably a base with a pKa value of 7 or greater and more preferably 8 or greater in aqueous solution.

As examples of such bases that are generated by irradiation there may be mentioned imidazoles, imidazole derivatives such as 2,4-dimethylimidazole and 1-methylimidazole, piperazine, piperazine derivatives such as 2,5-dimethylpiperazine, piperidine, piperidine derivatives such as 1,2-dimethylpiperidine, proline derivatives, trialkylamine derivatives such as trimethylamine, triethylamine and triethanolamine, pyridine derivatives having an amino group or alkylamino group substituted at the 4-position, such as 4-methylaminopyridine and 4-dimethylaminopyridine, pyrrolidine, pyrrolidine derivatives such as n-methylpyrrolidine, triethylenediamine, alicyclic amine derivatives such as 1,8-diazabiscyclo(5,4,0)undecene-1 (DBU), benzylamine derivatives such as benzylmethylamine, benzyldimethylamine and benzyldiethylamine, morpholine derivatives, primary alkylamines, and the like.

As examples of photobase generators that generate such bases by irradiation, there may be used the quaternary ammonium salt derivatives described in Journal of Photopolymer Science and Technology Vol. 12, 313-314 (1999) or Chemistry of Materials Vol. 11, 170-176 (1999). These are optimal for curing of the epoxy resin as component (B), in order to produce trialkylamines with high basicity by exposure to active light rays.

As photobase generators, there may be used the carbamic acid derivatives mentioned in Journal of American Chemical Society Vol. 118 p.12925(1996) or Polymer Journal Vol. 28 p.795(1996).

There may also be used oxime derivatives that generate primary amino groups under exposure to active light rays, 2-methyl-1-(4-(methylthio)phenyl)-2-morpholinopropan-1-one (IRGACURE 907 by Ciba Specialty Chemicals, Inc.), 2-benzyl-2-dimethylamino-1-(4-morpholinophenyl)-butanone-1 (IRGACURE 369 by Ciba Specialty Chemicals, Inc.), 3,6-bis-(2methyl-2-morpholino-propionyl)-9-N-octylcarbazole (OPTOMER N-1414 by ADEKA), which are commercially available as a photoradical generators, hexaarylbisimidazole derivatives (optionally having substituents such as halogens, alkoxy, nitro or cyano on the phenyl groups), benzoisooxazolone derivatives, and the like.

The photobase generator may also employ a compound having a base-generating group introduced on the main chain and/or a side chain of the polymer. The molecular weight in this case is preferably a weight-average molecular weight of 1,000-100,000 and more preferably 5,000-30,000, from the viewpoint of adhesion and flow property as an adhesive.

Since the photobase generator does not exhibit reactivity with the epoxy resin as component (B) when not exposed to radiation at room temperature, it is characterized by having highly excellent storage stability at room temperature.

From the viewpoint of heat resistance, the (D1) photoinitiator used for the invention is preferably a compound with an oxime ester group represented by general formula (21) below and/or a compound with a morpholine ring represented by general formula (22) below or general formula (23) below. These compounds may be used alone or in combinations.

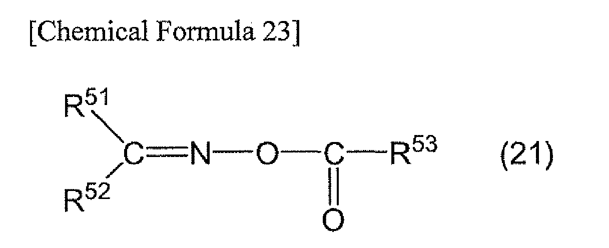

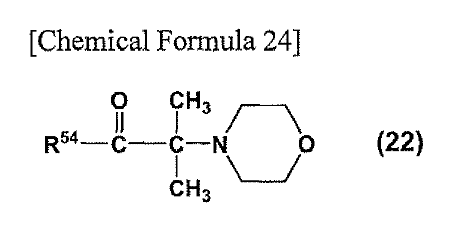

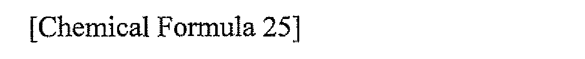

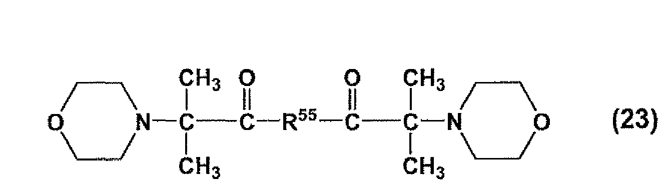

[In the formulas, R⁵¹ and R⁵² each independently represent hydrogen, C1-7 alkyl or an aromatic hydrocarbon group-containing organic group, and R⁵³ represents C1-7 alkyl or an aromatic hydrocarbon group-containing organic group. Also, R⁵⁴ and R⁵⁵ represent aromatic hydrocarbon group-containing organic groups.]

There are no particular restrictions on aromatic hydrocarbon groups, and as examples there may be mentioned phenyl, naphthyl, benzoin derivatives, carbazole derivatives, thioxanthone derivatives and benzophenone derivatives. The aromatic hydrocarbon group may also have substituents.

The molar absorption coefficient of the (D1) photoinitiator for light with a wavelength of 365 nm is preferably 1000 ml/g·cm or greater. The molar absorption coefficient can be determined by preparing a 0.001 wt% acetonitrile solution of the sample and measuring the absorbance of the solution using a spectrophotometer ("U-3310" (trade name) by Hitachi High-Technologies Corp.).

From the viewpoint of reducing outgas and improving the high-temperature adhesion the (D1) photoinitiator preferably has a 5% weight reduction temperature of 150°C or higher. The 5% weight reduction temperature of the photoinitiator is the 5% weight reduction temperature as measured for the sample using a differential thermogravimetric simultaneous measurement apparatus (TG/DTA6300 by SII NanoTechnology Inc.) with a temperature-elevating rate of 10°C/min and under a nitrogen flow (400 ml/min).

Particularly preferred for the (D1) photoinitiator are oxime esters and/or compounds with morpholine rings, which are compounds having a molar absorption coefficient of 1000 ml/g·cm or greater for light with a wavelength of 365 nm and having a 5% weight reduction temperature of 180°C or higher.

As examples of such compounds for the (D1) photoinitiator there may be mentioned compounds represented by structural formula (I-1) below, compounds represented by structural formula (I-2) below and compounds represented by structural formula (I-3) below.

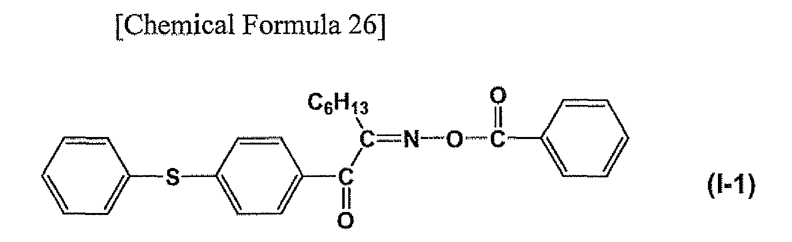

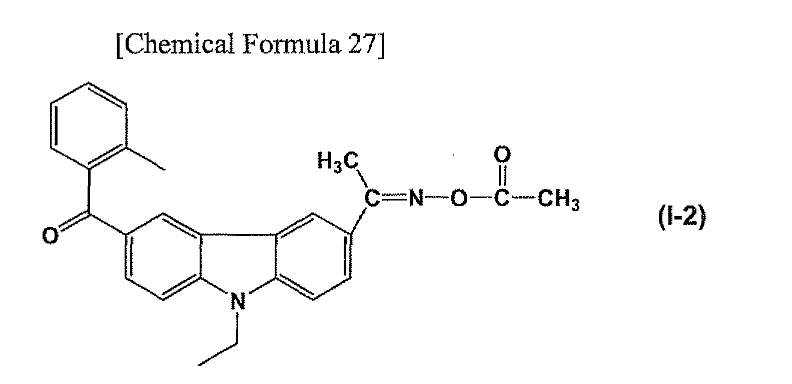

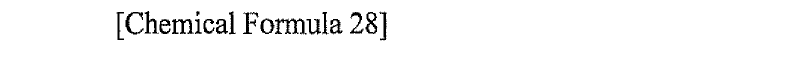

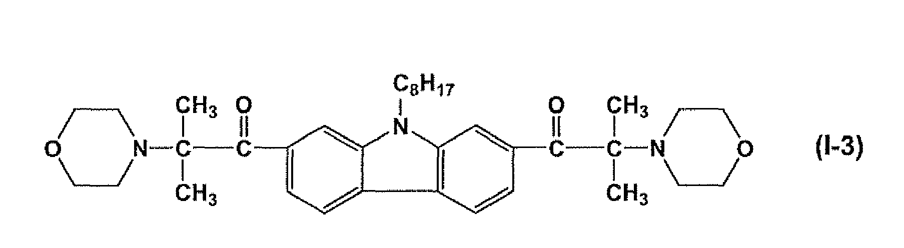

These compounds may be used alone or in combinations.

In addition to using a photobase generator that generates a base by irradiation, the epoxy resin as component (B) can also be cured by generating a base by reaction such as photo Fries rearrangement, photo Claisen rearrangement, Curtius rearrangement, or Stevens rearrangement.

When the photosensitive adhesive composition of the invention contains a photobase generator, a sensitizing agent may also be used as necessary. As examples of sensitizing agents there may be mentioned camphorquinone, benzyl, diacetyl, benzyldimethylketal, benzyldiethylketal, benzyldi(2-methoxyethyl)ketal, 4,4'-dimethylbenzyl-dimethylketal, anthraquinone, 1-chloroanthraquinone, 2-chloroanthraquinone, 1,2-benzanthraquinone, 1-hydroxyanthraquinone, 1-methylanthraquinone, 2-ethylanthraquinone, 1-bromoanthraquinone, thioxanthone, 2-isopropylthioxanthone, 2-nitrothioxanthone, 2-methylthioxanthone, 2,4-dimethylthioxanthone, 2,4-diethylthioxanthone, 2,4-diisopropylthioxanthone, 2-chloro-7-trifluoromethylthioxanthone, thioxanthone-10,10-dioxide, thioxanthone-10-oxide, benzoinmethyl ether, benzoinethyl ether, isopropyl ether, benzoinisobutyl ether, benzophenone, bis(4-dimethylaminophenyl)ketone, 4,4'-bisdiethylaminobenzophenone and compounds containing azide groups. Any of these may be used alone or two or more may be used in admixture.

When the photosensitive adhesive composition of the invention contains a compound with an oxime ester and/or morpholine ring as component (D1), the photosensitive adhesive composition may further contain a different photoinitiator. When the photosensitive adhesive composition is used as an adhesive layer with a film thickness of no greater than 3 0 µm, a compound with an oxime ester and/or morpholine ring may be added alone, or it may be used together with another photoinitiator if it is to be made into an adhesive layer with a film thickness of 50 µm or greater.

As other photoinitiators there are preferred those with absorption at 300-500 nm, and more preferably those that undergo bleaching by photoirradiation.

As examples of such photoinitiators there may be mentioned compounds that undergo photodiscoloration under UV irradiation, among aromatic ketones such as 2-benzyl-2-dimethylamino-1-(4-morpholinophenyl)-butanone-1, 2,2-dimethoxy-1,2-diphenylethan-1-one, 1-hydroxy-cyclohexyl-phenyl-ketone, 2-methyl-1-(4-(methylthio)phenyl)-2-morpholinopropanone-1,2,4-diethylthioxanthone, 2-ethylanthraquinone and phenanthrenequinone, benzyl derivatives such as benzyldimethylketal, 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer and 2-(2,4-dimethoxyphenyl)-4,5-diphenylimidazole dimer, acridine derivatives such as 9-phenylacridine and 1,7-bis(9,9'-acridinyl)heptane, and bisacylphosphine oxides such as bis(2,6-dimethoxybenzoyl)-2,4,4-trimethyl-pentylphosphine oxide and bis(2,4,6,-trimethylbenzoyl)-phenylphosphine oxide. These may be used alone or in combinations of two or more.

The content of component (D) in the photosensitive adhesive composition of the invention is not particularly restricted but is preferably 0.01-50 parts by weight with respect to 100 parts by weight of component (B).

The content of component (D1) in component (D) in the photosensitive adhesive composition of the invention is preferably 0.05-80 parts by weight with respect to 100 parts by weight as the total of component (D).

A filler may also be used in the photosensitive adhesive composition of the invention. As fillers there may be used, for example, metal fillers such as silver powder, gold dust, copper powder and nickel powder, inorganic fillers such as alumina, aluminum hydroxide, magnesium hydroxide, calcium carbonate, magnesium carbonate, calcium silicate, magnesium silicate, calcium oxide, magnesium oxide, aluminum oxide, aluminum nitride, crystalline silica, amorphous silica, boron nitride, titania, glass, iron oxide and ceramics, and organic fillers such as carbon and rubber-based fillers, without any particular restrictions on the type or form.

The filler may be selected for use according to the desired function. For example, a metal filler is added to impart conductivity, thermal conductivity or a thixotropic property to the photosensitive adhesive composition, a non-metal inorganic filler is added to impart thermal conductivity, a low thermal expansion property or low hygroscopicity to the adhesive layer, and an organic filler is added to impart toughness to the adhesive layer. These metal fillers, inorganic fillers or organic fillers may be used alone or in combinations of two or more. Metal fillers, inorganic fillers and insulating fillers are preferred from the viewpoint of imparting conductivity, thermal conductivity, a low moisture absorption property and an insulating property, which are required for semiconductor device adhesive materials, and among inorganic fillers and insulating fillers there are preferred silica fillers and/or alumina fillers from the viewpoint of satisfactory dispersibility in resin varnishes and high adhesive force when hot.

Preferably, the mean particle size of the filler is no greater than 10 µm and the maximum particle size is no greater than 30 µm, and more preferably the mean particle size is no greater than 5 µm and the maximum particle size is no greater than 20 µm. If the mean particle size exceeds 10 µm and the maximum particle size exceeds 30 µm, it may be difficult to obtain an effect of improved fracture toughness. The lower limits are not particularly restricted but will normally be 0.001 µm for both.

The filler preferably satisfies both a mean particle size of no greater than 10 µm and a maximum particle size of no greater than 30 µm. The maximum particle size is no greater than 30 µm, but high adhesive strength may be difficult to obtain when using a filler with a mean particle size exceeding 10 µm. The mean particle size is no greater than 10 µm, but if a filler with a maximum particle size exceeding 30 µm is used, the grain size distribution will be widened and there will tend to be variation in the adhesive strength, while the surface will also tend to be roughened, lowering the adhesive force, when the photosensitive adhesive composition is worked into a thin-film.

The method for measuring the mean particle size and maximum particle size of the filler may be a method whereby the particle sizes of about 200 filler particles are measured using a scanning electron microscope (SEM). As an example of measurement using SEM, there may be mentioned a method in which a sample is prepared by using the adhesive layer to bond the semiconductor element and the semiconductor-mounting supporting member and then heat curing it (preferably at 150-200°C for 1-10 hours), and the center section of the sample is cut for observation of the cross-section by SEM. Here, the proportion of filler particles with particle sizes of 30 µm and smaller is preferably at least 80% of the entire filler.

The filler content in the photosensitive adhesive composition of the invention may be determined according to the properties and function to be imparted, but it is preferably 1-50 wt%, more preferably 2-40 wt% and even more preferably 5-30 wt% with respect to the total of the resin component and filler. Increasing the amount of filler can increase the high elastic modulus and effectively improve the dicing property (cuttability with a dicer blade), wire bonding property (ultrasonic wave efficiency) and hot adhesive strength. If the filler is increased above the necessary amount the thermocompression bonding property will tend to be impaired, and therefore the filler content is preferably limited to within the range specified above. The optimal filler content is determined for the desired balance of properties. In cases where a filler is used, mixing and kneading may be accomplished using an appropriate combination of dispersers such as an ordinary stirrer, kneader, triple roll, ball mill or the like.

Various coupling agents may also be added to the photosensitive adhesive composition of the invention to improve the interfacial bonding between different types of materials. As examples of coupling agents there may be mentioned silane-based, titanium-based and aluminum-based agents, among which silane-based coupling agents are preferred for a greater effect. The amount of coupling agent used is preferably 0.01-20 parts by weight with respect to 100 parts by weight of the (A) alkali-soluble resin used, from the standpoint of the effect, heat resistance and cost.

An ion scavenger may also be added to the photosensitive adhesive composition of the invention to adsorb ionic impurities and improve the insulating reliability when wet. There are no particular restrictions on such ion scavengers, and as examples there may be mentioned compounds known as copper inhibitors to prevent ionization and dissolution of copper, such as triazinethiol compound and bisphenol-based reducing agents, as well as inorganic ion adsorbents such as zirconium-based and antimony bismuth-based magnesium aluminum compounds. The amount of ion scavenger used is preferably 0.01-10 parts by weight with respect to 100 parts by weight of the (A) alkali-soluble resin, from the viewpoint of effect of the addition, heat resistance and cost.

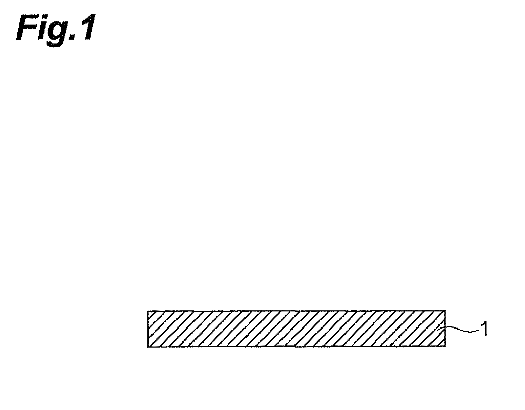

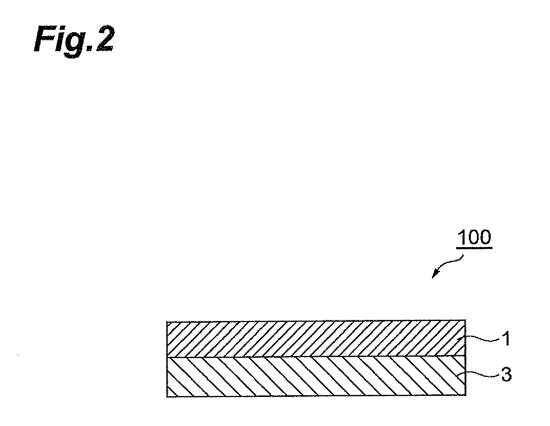

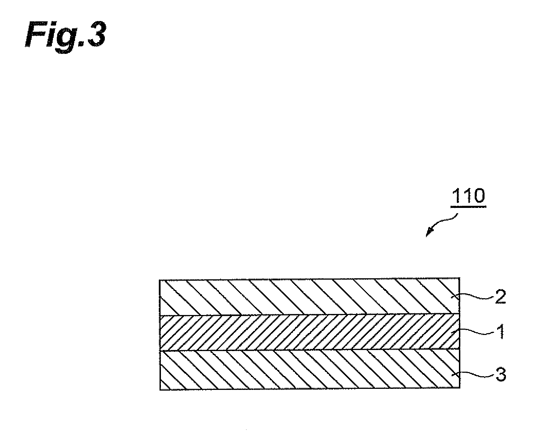

Fig. 1 is a schematic cross-sectional view showing an embodiment of a film-like adhesive according to the invention. The film-like adhesive (adhesive film) 1 shown in Fig. 1 is obtained by forming a film from the photosensitive adhesive composition. Fig. 2 is a schematic cross-sectional view showing an embodiment of an adhesive sheet according to the invention. The adhesive sheet 100 shown in Fig. 2 is constructed of a base 3, and an adhesive layer composed of an adhesive film 1 formed on one side of the base. Fig. 3 is a schematic cross-sectional view showing another embodiment of an adhesive sheet of the invention. The adhesive sheet 110 shown in Fig. 3 is constructed of a base 3, and an adhesive layer composed of an adhesive film 1, and a cover film 2, formed on one side of the base.

The film-like adhesive 1 can be obtained by a method in which the (A) alkali-soluble resin, (B) epoxy resin, (C) radiation-polymerizable compound and (D) photoinitiator containing (D1) a photoinitiator that exhibits a function of promoting polymerization and/or curing reaction of the epoxy resin by exposure to radiation, as well as other components added as necessary, are combined in an organic solvent and the mixture is kneaded to prepare a varnish, a varnish layer is formed on the base 3, and the varnish layer is dried by heating and the base 3 is subsequently removed. They may also be stored and used as adhesive sheets 100, 110, without removal of the base 3.

The mixing and kneading can generally be accomplished by an appropriate combination of dispersers such as a stirrer, kneader, triple roll or ball mill. Drying is carried out at a temperature so that the thermosetting resin, such as the (B) epoxy resin does not completely react during drying, and under conditions in which the solvent thoroughly volatilizes. Specifically, the varnish layer is dried by heating at usually 60-180°C for 0.1-90 minutes. The preferred thickness of the varnish layer before drying is 1-100 µm. A thickness of less than 1 µm will tend to impair the adhesive anchoring function, while a thickness of greater than 100 µm will tend to increase the residual volatile components described hereunder.

The preferred residual volatile component of the obtained varnish layer is no greater than 10 wt%. A residual volatile component of greater than 10 wt% will tend to leave voids inside the adhesive layer due to foam produced by volatilization of the solvent during assembly heating and will tend to impair the humidity-resistant reliability, while also increasing the potential for contamination of the surrounding material or members due to volatilizing components generated during heating. The measuring conditions of the residual volatilizing components were as follows. Specifically, the value for the film-like adhesive cut to a size of 50 mm × 50 mm was measured using [(M2-M1)/M1] × 100 = residual volatile component (%), where M1 is the initial weight and M2 is the weight after heating the film-like adhesive for 3 hours in an oven at 160°C.

The temperature at which the thermosetting resin does not completely react is, specifically, a temperature below the peak temperature for heat of reaction, with measurement using a DSC (for example, a "Model DSC-7" (trade name) by Perkin-Elmer), with a sample weight of 10 mg, a temperature-elevating rate of 5°C/min and a measuring atmosphere of air.

The organic solvent used to prepare the varnish, i.e. the varnish solvent, is not particularly restricted so long as it can uniformly dissolve or disperse in the material. As examples there may be mentioned dimethylformamide, toluene, benzene, xylene, methyl ethyl ketone, tetrahydrofuran, ethylcellosolve, ethylcellosolve acetate, dioxane, cyclohexanone, ethyl acetate and N-methyl-pyrrolidinone.

The base 3 is not particularly restricted so long as it can withstand the drying conditions. For example, a polyester film, polypropylene film, polyethylene terephthalate film, polyimide film, polyetherimide film, polyether naphthalate film or methylpentene film may be used as the base 3. A film used as the base 3 may also be a multilayer film comprising a combination of two or more different types, and the surface may be treated with a silicone-based or silica-based release agent.

The film-like adhesive 1 of the invention may be laminated with a dicing sheet to form an adhesive sheet. The dicing sheet is a sheet comprising a pressure-sensitive adhesive layer formed on a base, and the pressure-sensitive adhesive layer may be a pressure-sensitive type or radiation-curing type. The base is preferably an expandable base. Using such an adhesive sheet, it is possible to obtain an integrated dicing/die bond adhesive sheet having a function as a die bond film and also having a function as a dicing sheet.

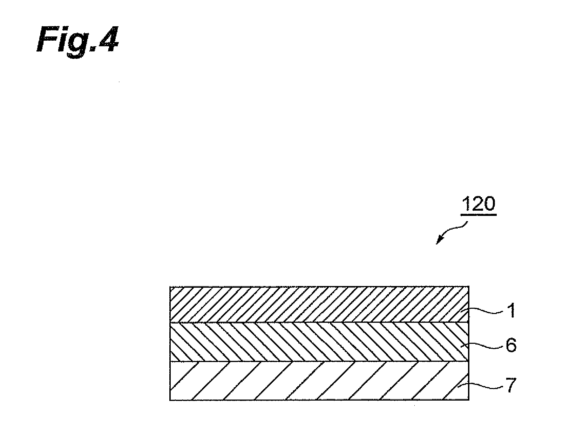

Specifically, the integrated dicing/die bond adhesive sheet may be an adhesive sheet 120 such as shown in Fig. 4, having a base film 7, pressure-sensitive adhesive layer 6 and a film-like adhesive 1 of the invention formed in that order.

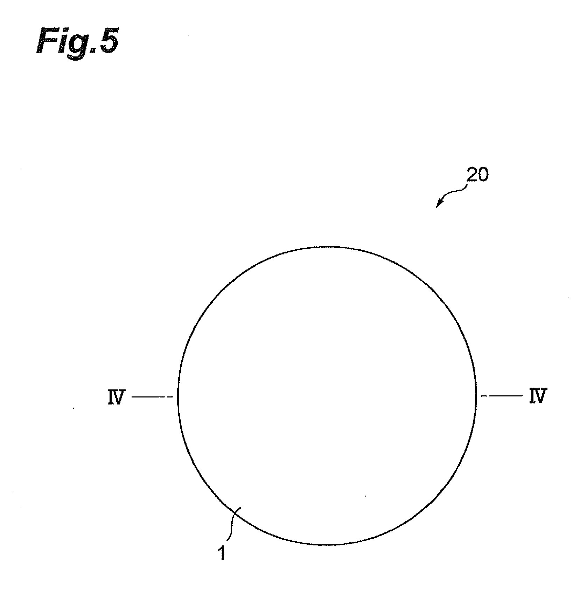

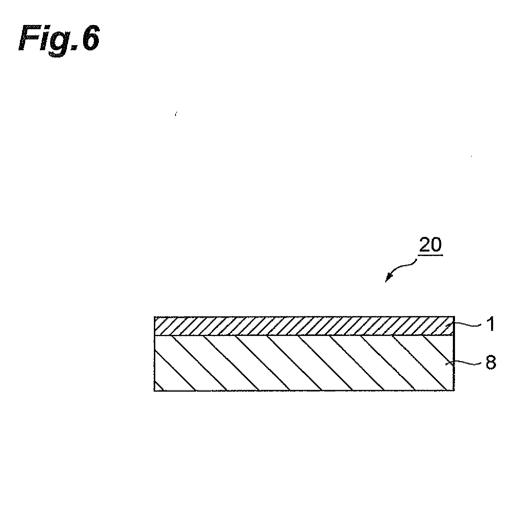

Fig. 5 is a top view showing an embodiment of a semiconductor wafer with an adhesive layer according to the invention, and Fig. 6 is an end view of Fig. 5 along line IV-IV. The semiconductor wafer with an adhesive layer 20 shown in Figs. 5 and 6 comprises a semiconductor wafer 8, and a film-like adhesive (adhesive layer) 1 composed of the aforementioned photosensitive adhesive composition, formed on one side thereof.

The semiconductor wafer with an adhesive layer 20 is obtained by laminating the film-like adhesive 1 on the semiconductor wafer 8 while heating. Since the film-like adhesive 1 is a film composed of the aforementioned photosensitive adhesive composition, it can be attached to the semiconductor wafer 8 at low temperatures of, for example, room temperature (25°C) to about 150°C.

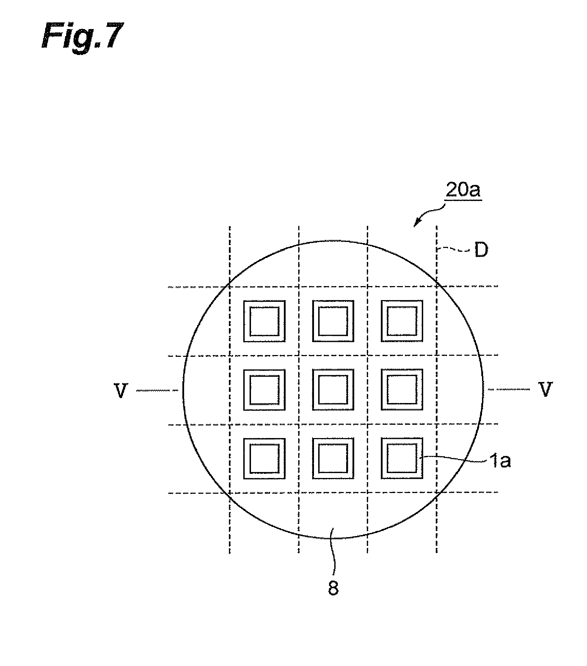

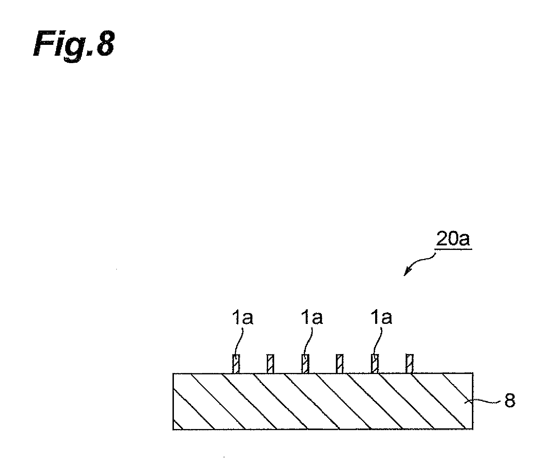

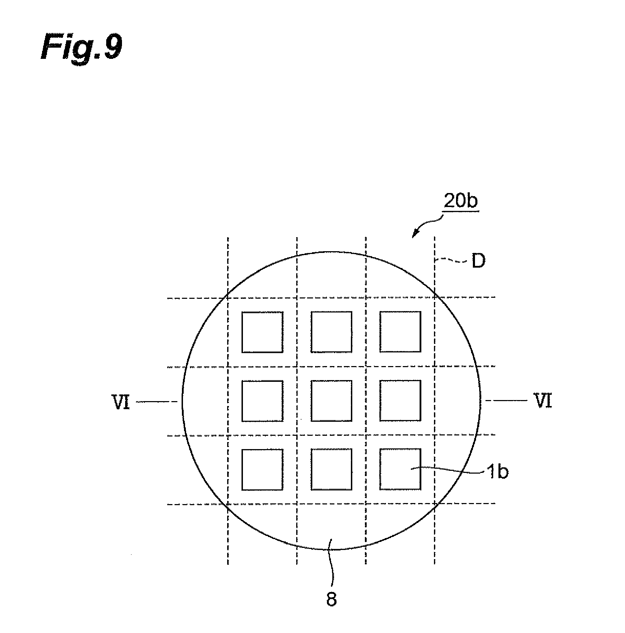

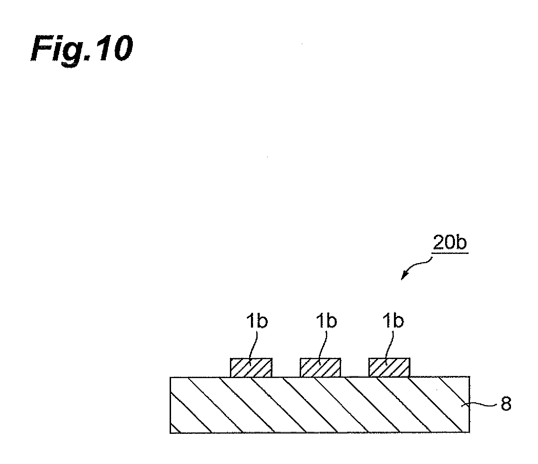

Fig. 7 and Fig. 9 are top views showing embodiments of an adhesive pattern according to the invention, Fig. 8 is an end view of Fig. 7 along line V-V, and Fig. 10 is an end view of Fig. 9 along line VI-VI. The adhesive patterns 1a and 1b shown in Figs. 7, 8, 9 and 10 are formed on the semiconductor wafer 8 as the adherend, so as to form patterns along roughly square sides, or square patterns.

The adhesive patterns 1a and 1b are formed by forming the adhesive layer 1 composed of a photosensitive adhesive composition on the semiconductor wafer 8 as the adherend to obtain a semiconductor wafer with an adhesive layer 20, exposing the adhesive layer 1 through a photomask, and developing the exposed adhesive layer 1 with an alkali developing solution. This will yield semiconductor wafers with adhesive layers 20a, 20b on which adhesive patterns 1a, 1b have been formed.

The use of the film-like adhesive of the invention will now be explained in detail, with reference to drawings of semiconductor devices comprising film-like adhesives. Incidentally, semiconductor devices with various structures have been proposed in recent years, and use of the film-like adhesive of the invention is not limited to semiconductor devices having the structures described below.

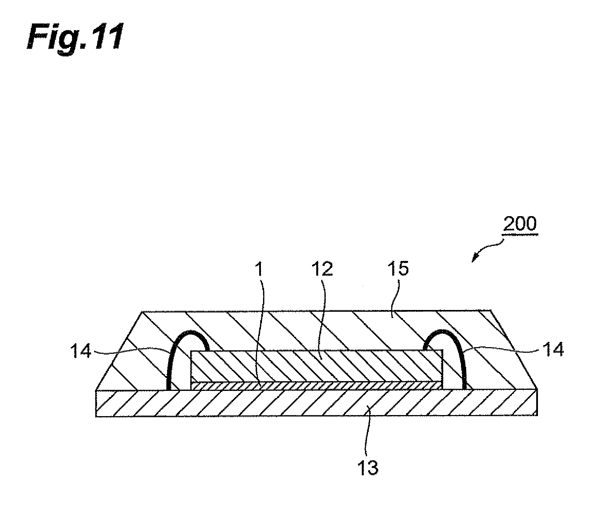

Fig. 11 is a schematic cross-sectional view showing an embodiment of a semiconductor device according to the invention. In the semiconductor device 200 shown in Fig. 11, the semiconductor element 12 is bonded to the semiconductor element-mounting supporting member 13 via the film-like adhesive 1, and the connecting terminals (not shown) of the semiconductor element 12 are electrically connected to the external connecting terminals (not shown) via wires 14, and sealed with a sealing material 15.

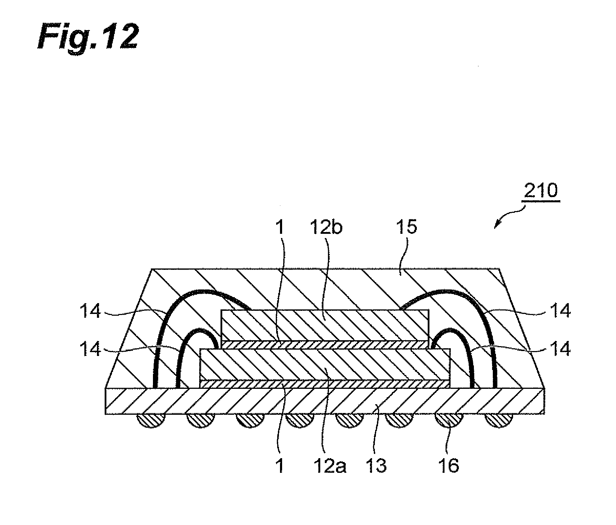

Fig. 12 is a schematic cross-sectional view showing another embodiment of a semiconductor device according to the invention. In the semiconductor device 210 shown in Fig. 12, the first-level semiconductor element 12a is bonded to the semiconductor element-mounting supporting member 13 on which terminals 16 have been formed, via a film-like adhesive 1 of the invention, and the second-level semiconductor element 12b is bonded on the first-level semiconductor element 12a also via a film-like adhesive 1 of the invention. The connecting terminals (not shown) of the first-level semiconductor element 12a and second-level semiconductor element 12b are electrically connected with external connecting terminals via wires 14, and are sealed with a sealing material. Thus, the film-like adhesive of the invention may be suitably used in a semiconductor device having a construction with a plurality of layered semiconductor elements.

The semiconductor devices (semiconductor packages) shown in Fig. 11 and Fig. 12 can be obtained, for example, by dicing the semiconductor wafer 20b shown in Fig. 9 along the dotted lines D, thermocompression bonding the diced film-like adhesive-attached semiconductor element onto the semiconductor element-mounting supporting member 13 to bond them, and then passing it through a wire bonding step, and if necessary also a sealing step with a sealing material. The heating temperature for thermocompression bonding is normally 20-250°C, the load is normally 0.01-20 kgf and the heating time is normally 0.1-300 seconds.

### Examples

The present invention will now be explained in greater detail based on examples and comparative examples, with the understanding that the invention is in no way limited to the examples.

### (Synthesis of polyimide PI-1)

In a flask equipped with a stirrer, thermometer, condenser tube and nitrogen substitution device there were charged 1.89 g of 3,5-diaminobenzoic acid (molecular weight: 152.2, hereunder abbreviated as "DABA"), 15.21 g of aliphatic etherdiamine ("D-400" (trade name) by BASF, molecular weight: 452.4), 0.39 g of 1,1,3,3-tetramethyl-1,3-bis(4-aminophenyl)disiloxane ("LP-7100" (trade name) of Shin-Etsu Chemical Co., Ltd., molecular weight: 248.5) and 116 g of N-methyl-2-pyrrolidinone (hereunder abbreviated as "NMP").

Next, 16.88 g of 4,4'-oxydiphthalic dianhydride (molecular weight: 326.3, hereunder abbreviated as "ODPA") was added to the flask in small portions at a time while cooling the flask in an ice bath. Upon completion of the addition, the mixture was further stirred at room temperature (25°C) for 5 hours.

A moisture receptor-equipped reflux condenser was then mounted on the flask, 70 g of xylene was added, and the temperature was increased to 180°C while blowing in nitrogen gas to maintain the temperature for 5 hours, and the xylene was azeotropically removed with the water. The obtained solution was cooled to room temperature and then poured into distilled water for reprecipitation. The obtained precipitate was dried with a vacuum dryer to obtain a polyimide resin (hereunder referred to as ""polyimide PI-1"). GPC measurement of the obtained polyimide resin resulted in Mw = 33,000 based on polystyrene. The Tg of the obtained polyimide resin was 55°C.

### (Synthesis of polyimide PI-2)

In a flask equipped with a stirrer, thermometer and nitrogen substitution device there were charged 2.16 g of 5,5'-methylene-bis(anthranilic acid) (molecular weight: 286.3, hereunder abbreviated as "MBAA"), 15.13 g of aliphatic etherdiamine ("D-400"), 1.63 g of 1,1,3,3-tetramethyl-1,3-bis(4-aminophenyl)disiloxane ("LP-7100") and 115 g of NMP.

Next, 16.51 g of ODPA was added to the flask in small portions at a time while heating the flask in an ice bath. Upon completion of the addition, the mixture was further stirred at room temperature for 5 hours. A moisture receptor-equipped reflux condenser was then mounted on the flask, 81 g of xylene was added, the temperature was increased to 180°C while blowing in nitrogen gas to maintain the temperature for 5 hours, and the xylene was azeotropically removed with the water. The obtained solution was cooled to room temperature and then poured into distilled water for reprecipitation, to obtain a polyimide resin (hereunder referred to as "polyimide PI-2"). GPC measurement of the obtained polyimide resin resulted in Mw = 30,000 based on polystyrene. The Tg of the obtained polyimide resin was 31°C.

### (Synthesis of polyimide PI-3)

In a flask equipped with a stirrer, thermometer and nitrogen substitution device there were charged 20.5 g of 2,2-bis(4-(4-aminophenoxy)phenyl)propane (molecular weight: 410.5, hereunder abbreviated as "BAPP") and 101 g of NMP.

Next, 20.5 g of 1,2-(ethylene)bis(trimellitate anhydride) (molecular weight: 410.3, hereunder abbreviated as "EBTA") was added to the flask in small portions at a time while cooling the flask in an ice bath. Upon completion of the addition, the mixture was further stirred at room temperature for 5 hours. A moisture receptor-equipped reflux condenser was then mounted on the flask, 67 g of xylene was added, the temperature was increased to 180°C while blowing in nitrogen gas to maintain the temperature for 5 hours, and the xylene was azeotropically removed with the water. The obtained solution was cooled to room temperature and then poured into distilled water for reprecipitation, to obtain a polyimide resin (hereunder referred to as "polyimide PI-3"). GPC measurement of the obtained polyimide resin resulted in Mw = 98,000 based on polystyrene. The Tg of the obtained polyimide resin was 180°C.

### (Examples 1-7 and Comparative Examples 1-4)

The polyimides PI-1 to -3 were used for mixing of the components in the compositional ratio listed in Table 1 (units: parts by weight), to obtain photosensitive adhesive compositions (adhesive layer-forming varnishes).

The symbols for the components in Table 1 and Table 2 have the following meanings.
E-3708: Epoxy acrylate by Daicel-Cytec Co., Ltd.
U-2PPA: Urethane acrylate by Shin-Nakamura Chemical Corp.
YDF-8170: Bisphenol F-type epoxy resin by Tohto Kasei Co., Ltd.
BEO-60E: Bisphenol A bis(triethyleneglycolglycidyl ether)ether by
New Japan Chemical Co., Ltd.
TrisP-PA: Trisphenol compound (α,α,α'-tris(4-hydroxyphenol)-1-ethyl-4-isopropylbenzene) by Honshu Chemical Industry
R972: Hydrophobic fumed silica (mean particle size: approximately 16 nm) by Nippon Aerosil Co., Ltd.
I-819: bis(2,4,6-Trimethylbenzoyl)-phenylphosphine oxide (5% weight reduction temperature: 210°C, molar absorption coefficient at 365 nm: 2300 ml/g·cm) by Ciba Specialty Chemicals Co., Ltd.
I-OXE01: 2,4-Dimethoxy-1,2-diphenylethan-1-one, 1,2-octanedione, 1-[4-(phenylthio)-2-(O-benzoyloxime)], oxime ester group-containing photoinitiator (5% weight reduction temperature: 220°C, molar absorption coefficient at 365 nm: 7000 ml/g·cm) by Ciba Specialty Chemicals Co., Ltd.
I-OXE02: Ethanone, 1-[9-ethyl-6-(2-methylbenzoyl)-9H-carbazol-3-yl]-,1- (O-acetyloxime), oxime ester group-containing compound (5% weight reduction temperature: 370°C, molar absorption coefficient at 365 nm: 7700 ml/g·cm) by Ciba Specialty Chemicals Co., Ltd.
I-907: 2-Methyl-1-[4-(methylthio)phenyl]-2-morpholinopropane, morpholine ring-containing photoinitiator (5% weight reduction temperature: 220°C, molar absorption coefficient at 365 nm: 450 ml/g·cm) by Ciba Specialty Chemicals Co., Ltd.
N-1919: Non-disclosed structure, oxime ester group-containing photoinitiator (5% weight reduction temperature: 280°C, molar absorption coefficient at 365 nm: 4500 ml/g·cm) by ADEKA Corp.
N-1414: 3,6-bis-(2-Methyl-2-morpholino-propionyl)-9-N-octylcarbazole, morpholine ring-containing photoinitiator (5% weight reduction temperature: 350°C, molar absorption coefficient at 365 nm: 2000 ml/g·cm) by ADEKA Corp.
OXAZ: 3-phenyl-5-isooxazolone, oxime ester group-containing compound (5% weight reduction temperature: 140°C, molar absorption coefficient at 365 nm: <10 ml/g·cm) by Aldrich
NMP: N-methyl-2-pyrrolidinone by Kanto Kagaku Co., Ltd.

The 5% weight reduction temperature of the photoinitiator is the value measured using a differential thermogravimetric simultaneous measurement apparatus ("TG/DTA 6300" (trade name) by SII NanoTechnology Inc.), under conditions with a nitrogen flow of 400 ml/min.

**[Table 1]**

| Composition | | Examples | | | | | | |
|---|---|---|---|---|---|---|---|---|
| | | 1 | 2 | 3 | 4 | 5 | 6 | 7 |
| Polyimide | PI-1 | 100 | - | - | 100 | 100 | - | - |
| | PI-2 | - | 100 | 100 | - | - | 100 | 100 |
| Radiation-polymerizing compound | E-3708 | 40 | 40 | 40 | 40 | 40 | 40 | 40 |
| | U-2PPA | 40 | 40 | 40 | 40 | 40 | 40 | 40 |
| Epoxy | YDF-8170 | 5 | 5 | 5 | 5 | 5 | 5 | 5 |
| resin | BEO-60E | 10 | 10 | 10 | 10 | 10 | 10 | 10 |
| Curing agent | TrisP-PA | 5 | 5 | 5 | 5 | 5 | 5 | 5 |
| Filler | R-972 | 5 | 5 | 5 | 5 | 5 | 5 | 5 |
| Photoinitiator | I-819 | - | 1.5 | 2 | 2 | 2 | 2 | - |
| | I-OXE01 | - | - | 1 | - | - | - | - |
| | I-OXE02 | 3 | 1.5 | - | - | - | - | - |
| | I-907 | - | - | - | 1 | - | - | - |
| | N-1919 | - | - | - | - | 1 | - | - |
| | N-1414 | - | - | - | - | - | 1 | 3 |
| Coating solvent | NMP | 200 | 203 | 210 | 200 | 210 | 212 | 211 |

**[Table 2]**

| Composition | | Comp. Ex. | | | |
|---|---|---|---|---|---|
| | | 1 | 2 | 3 | 4 |
| Polyimide | PI-1 | - | - | - | 100 |
| | PI-2 | 100 | - | 100 | - |
| | PI-3 | - | 100 | - | - |
| Radiation-polymerizing compound | E-3708 | 40 | - | 40 | 40 |
| | U-2PPA | 40 | - | 40 | 40 |
| Epoxy resin | YDF-8170 | 5 | 5 | 5 | 5 |
| | BEO-60E | 10 | 10 | 10 | 10 |
| Curing agent | TrisP-PA | 5 | 5 | 5 | 5 |
| Filler | R-972 | 5 | 5 | 5 | 5 |
| Photoinitiator | I-819 | 3 | - | 1.5 | - |
| | OXAZ | - | - | 1.5 | 3 |
| Coating solvent | NMP | 270 | 200 | 254 | 245 |

Each of the obtained adhesive layer-forming varnishes was coated onto a base (release agent-treated PET film) to a post-drying thickness of 50 µm, and then heated in an oven at 80°C for 30 minutes and then at 120°C for 30 minutes to obtain adhesive sheets for Examples 1-7 and Comparative Examples 1-4 having adhesive layers formed on bases.

### <Evaluation of low-temperature attachment property>

Each of the adhesive sheets obtained in Examples 1-7 and Comparative Examples 1-4 was laminated onto the back side of a silicon wafer (6-inch diameter, 400 µm thickness) placed on a support stage (the side opposite the support stage side), by orienting the adhesive layer to the silicon wafer side and pressing with a roll (temperature: 100°C, linear pressure: 4 kgf/cm, feed rate: 0.5 m/min). Next, the base (PET film) was peeled off and an 80 µm-thick, 10 mm-wide, 40 mm-long polyimide film (UPILEX, trade name of Ube Industries, Ltd.) was pressed onto the adhesive layer with a roll under the same conditions described above for lamination. Each sample prepared in this manner was subjected to a 90° peel test at room temperature using a rheometer (STROGRAPH E-S (trade name) by Toyo Seiki Laboratories), for measurement of the adhesive layer-UPILEX peel strength. Samples with a peel strength of 2 N/cm or greater were evaluated as A, and samples with less than 2 N/cm were evaluated as B, based on the measurement results. The results are shown in Tables 3 and 4.

### <Evaluation of pattern formability>

Each of the adhesive sheets of Examples 1-7 and Comparative Examples 1, 3 and 4 was laminated onto a silicon wafer (6-inch diameter, 400 µm thickness) at a temperature of 100°C while the adhesive sheet of Comparative Example 2 was laminated at a temperature of 300°C, by orienting the adhesive layer to the silicon wafer side and pressing with a roll (linear pressure: 4 kgf/cm, feed rate: 0.5 m/min).

Next, a negative pattern mask ("No.G-2" (trade name) by Hitachi Chemical Co., Ltd.) was placed on the base (PET film) and exposed at 500 mJ/cm² with a high precision parallel exposure apparatus ("EXM-1172-B-∞ (trade name) by Orc Manufacturing Co., Ltd.), and allowed to stand for approximately 30 seconds on a hot plate at 80°C.

The base (PET film) was then removed, and a conveyor developing machine (Yako Co., Ltd.) was used for spray development with a 2.38 wt% solution of tetramethylammonium hydride (TMAH) as the developing solution, a temperature of 28°C and a spray pressure of 0.18 MPa, after which it was washed with purified water at a temperature of 23°C and a spray pressure of 0.02 MPa. After development, it was visually confirmed whether a pattern with line width/space width = 200 µm/400 µm had been formed, and an evaluation of A was assigned for pattern formation while B was assigned for no pattern formation. The results are shown in Tables 3 and 4.

### <Evaluation of sensitivity>

Each of the adhesive sheets of Examples 1-7 and Comparative Examples 1, 3 and 4 was laminated onto a silicon wafer (6-inch diameter, 400 µm thickness) at a temperature of 100°C while the adhesive sheet of Comparative Example 2 was laminated at a temperature of 300°C, by orienting the adhesive layer to the silicon wafer side and pressing with a roll (linear pressure: 4 kgf/cm, feed rate: 0.5 m/min).

Next, a photomask (PHOTOTECH 41 step density tablet (trade name) by Hitachi Chemical Co., Ltd.), commonly known as a step tablet, was placed on the base (PET film) as a negative pattern photomask, in such a manner for decreasing light transmittance in a stepwise manner, and exposed at 500 mJ/cm² with a high precision parallel exposure apparatus ("EXM-1172-B-∞" (trade name) by Orc Manufacturing Co., Ltd.), and then allowed to stand on a hot plate at 80°C for approximately 30 seconds.

The base (PET film) was then removed, and a conveyor developing machine (Yako Co., Ltd.) was used for spray development with a 2.38 wt% solution of tetramethylammonium hydride (TMAH) as the developing solution, a temperature of 26°C and a spray pressure of 0.18 MPa, after which it was washed with purified water at a temperature of 23°C and a spray pressure of 0.02 MPa. After development, the number of steps of the step tablet of the photocured film formed on the silicon wafer was counted to evaluate the photosensitivity of the adhesive sheet. Samples with 25 or more remaining steps were evaluated as A, and samples with fewer than 25 steps were evaluated as B, based on the measurement results. The results are shown in Tables 3 and 4.

### <Measurement of 260°C peel strength (evaluation of adhesion at high temperature)>

A silicon wafer (6-inch diameter, 400 µm thickness) was half-cut to a size of 5 mm × 5 mm and a depth of 180 µm. Each of the adhesive sheets of Examples 1-7 and Comparative Examples 1, 3 and 4 was then laminated onto the half-cut silicon wafer at a temperature of 100°C while the adhesive sheet of Comparative Example 2 was laminated at a temperature of 300°C, by orienting the adhesive layer to the silicon wafer side and pressing with a roll (linear pressure: 4 kgf/cm, feed rate: 0.5 m/min). The obtained sample was exposed at 500 mJ/cm² with a high precision parallel exposure apparatus ("EXM-1172-B-∞ (trade name) by Orc Manufacturing Co., Ltd.), and allowed to stand for approximately 30 seconds on a hot plate at 80°C. The base (PET film) was then removed and the sample was individuated to 5 mm × 5 mm.

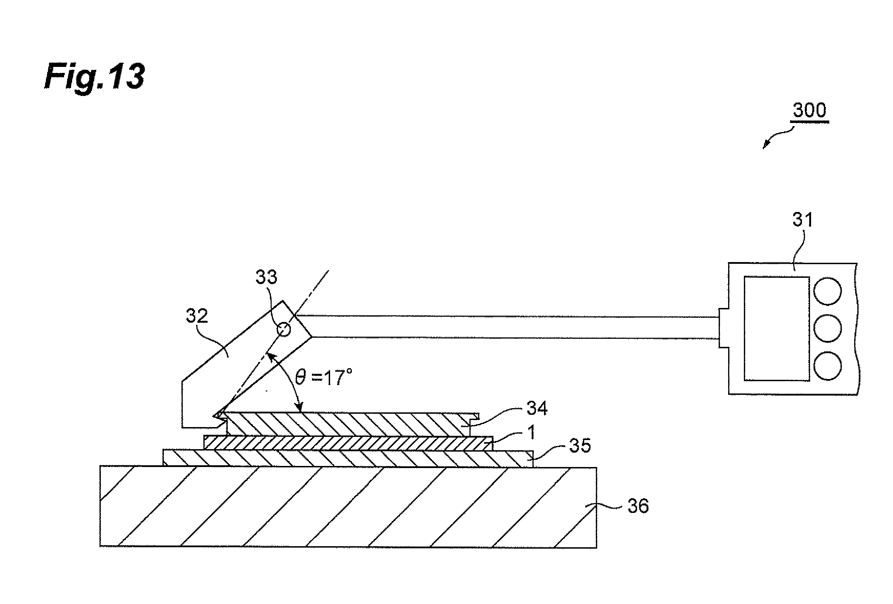

The individuated adhesive layer-attached silicon wafer was placed on a glass panel (10 mm × 10 mm × 0.55 mm) with the adhesive layer on the glass panel side, and contact bonded for 10 seconds at 120°C while pressing at 2 kgf. The obtained test piece was heat cured in an oven at 120°C for 3 hours. Next, the test piece was heated on a heating plate at 260°C for 10 seconds, and the peel strength tester shown in Fig. 13 was used to measure the peel strength of the silicon wafer at 260°C with a measuring speed of 0.5 mm/sec, with the value being recorded as the 260°C peel strength (before moisture absorption). The 260°C peel strength after moisture absorption was determined by measuring the 260°C peel strength in the same manner as above, after allowing the heat cured test piece to stand at 48 hours in a thermo-hygrostat at 85°C/85% RH. The results are shown in Tables 3 and 4.

In the peel strength tester 300 shown in Fig. 13, a handle 32 with variable angle around a fulcrum 33 is provided at the end of a rod mounted on a push-pull gauge 31. Measurement of the 260°C peel strength was accomplished by placing the test piece, comprising a silicon wafer 34 with a protrusion and a glass panel 35 bonded via an adhesive layer 1, on a heating plate 36 at 260°C and, with the handle 32 engaged with the protrusion of the silicon wafer 34, using the push-pull gauge 31 to measure the peel stress when the handle 32 was moved at 0.5 mm/sec.

### <5% Weight reduction temperature of cured adhesive>

Each of the adhesive sheets of Examples 1-7 and Comparative Examples 1, 3 and 4 was laminated onto a silicon wafer (6-inch diameter, 400 µm thickness) at a temperature of 100°C while the adhesive sheet of Comparative Example 2 was laminated at a temperature of 300°C, by orienting the adhesive layer to the silicon wafer side and pressing with a roll (linear pressure: 4 kgf/cm, feed rate: 0.5 m/min).

Next, the obtained sample was exposed at 500 mJ/cm² with a high precision parallel exposure apparatus ("EXM-1172-B-∞ (trade name) by Orc Manufacturing Co., Ltd.), and allowed to stand for approximately 30 seconds on a hot plate at 80°C. The base (PET film) was then removed and heat cured in an oven at 120°C for 3 hours. The cured adhesive was shaved off from the silicon wafer, and the 5% weight reduction temperature was measured using a differential thermogravimetric simultaneous measurement apparatus ("TG/DTA 6300" (trade name) by SII NanoTechnology Inc.), under conditions with a nitrogen flow of 400 ml/min. The results are shown in Tables 3 and 4.

**[Table 3]**

| Properties | | Examples | | | | | | |
|---|---|---|---|---|---|---|---|---|
| | | 1 | 2 | 3 | 4 | 5 | 6 | 7 |
| Low-temperature attachment property | | A | A | A | A | A | A | A |
| Pattern formability | | A | A | A | A | A | A | A |
| Sensitivity | | A | A | A | B | A | A | A |
| 260°C Peel strength (MPa) | Before moisture absorption | 1.0 | 0.7 | 0.6 | 0.8 | 0.8 | 1.0 | 1.0 |
| | After moisture absorption | 0.8 | 0.5 | 0.4 | 0.6 | 0.6 | 0.8 | 0.8 |
| 5% Weight reduction temperature (°C) | | 331 | 321 | 330 | 320 | 340 | 340 | 340 |

**[Table 4]**

| Properties | | Comp. Ex. | | | |
|---|---|---|---|---|---|
| | | 1 | 2 | 3 | 4 |
| Low-temperature attachment property | | A | B | A | A |
| Pattern formability | | A | B | A | A |
| Sensitivity | | B | B | B | B |
| 260°C Peel strength (MPa) | Before moisture absorption | 0.1 | 1.5 | 0.03 | 0.05 |
| | After moisture absorption | 0.05 | 1.1 | 0.02 | 0.04 |
| 5% Weight reduction temperature (°C) | | 330 | 332 | 223 | 235 |

### Industrial Applicability

According to the invention it is possible to provide a photosensitive adhesive composition with excellent pattern formability, adhesion after pattern formation, heat resistance and humidity-resistant reliability after bonding, and excellent low-temperature attachment properties after being formed into a film, as well as a film-like adhesive, an adhesive sheet, an adhesive pattern, a semiconductor wafer with an adhesive layer, a semiconductor device and a semiconductor device manufacturing method, which employ the same.

## Claims

1. A photosensitive adhesive composition comprising
(A) an alkali-soluble resin,
(B) an epoxy resin,
(C) a radiation-polymerizable compound and
(D) a photoinitiator,
wherein the (D) photoinitiator contains at least (D1) a photoinitiator that exhibits a function which promotes polymerization and/or curing reaction of the epoxy resin by exposure to radiation.

2. A photosensitive adhesive composition according to claim 1, wherein the (D1) photoinitiator is a compound that generates a base by exposure to radiation.

3. A photosensitive adhesive composition according to claim 1 or 2, wherein the (D1) photoinitiator is a compound with an oxime ester and/or morpholine ring.

4. A photosensitive adhesive composition according to any one of claims 1 to 3, wherein the molar absorption coefficient of the (D1) photoinitiator for light with a wavelength of 365 nm is 1000 ml/g·cm or greater.

5. A photosensitive adhesive composition according to any one of claims 1 to 4, wherein the 5% weight reduction temperature of the (D1) photoinitiator is 150°C or higher.

6. A photosensitive adhesive composition according to any one of claims 1 to 5, wherein the (D1) photoinitiator is a compound represented by structural formula (I-1) below and/or a compound represented by structural formula (1-2) below and/or a compound represented by structural formula (1-3) below.

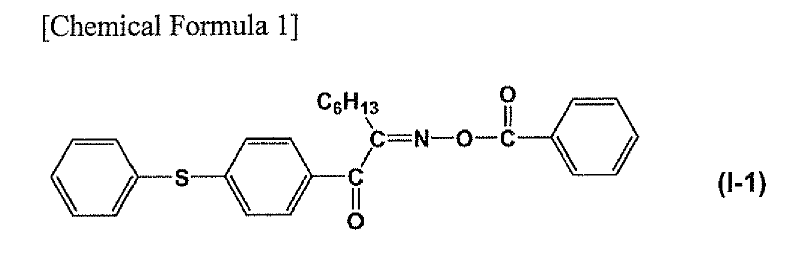

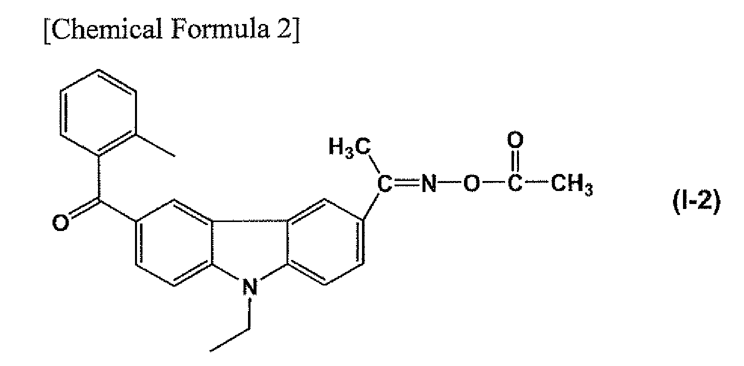

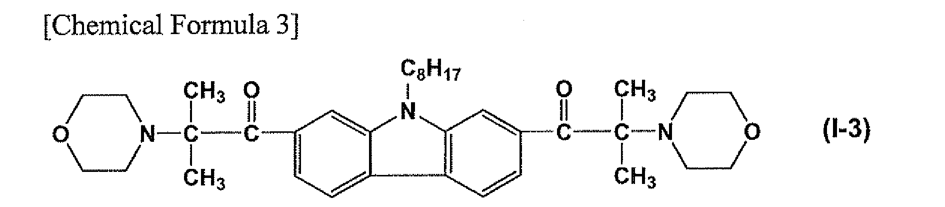

7. A photosensitive adhesive composition according to any one of claims 1 to 6, wherein the glass transition temperature of the (A) alkali-soluble resin is no higher than 150°C.

8. A photosensitive adhesive composition according to any one of claims 1 to 7, wherein the (A) alkali-soluble resin is a resin with a carboxyl and/or hydroxyl group.

9. A photosensitive adhesive composition according to any one of claims 1 to 8, wherein the (A) alkali-soluble resin is a polyimide resin.

10. A photosensitive adhesive composition according to claim 9, wherein the polyimide resin is a polyimide resin obtained by reaction between a tetracarboxylic dianhydride and a diamine with a carboxyl and/or hydroxyl group in the molecule.

11. A photosensitive adhesive composition according to claim 13 or 14, wherein the polyimide resin is a polyimide resin obtained by reaction between a tetracarboxylic dianhydride and an aromatic diamine represented by structural formula (3) below and/or an aromatic diamine represented by structural formula (4) below.

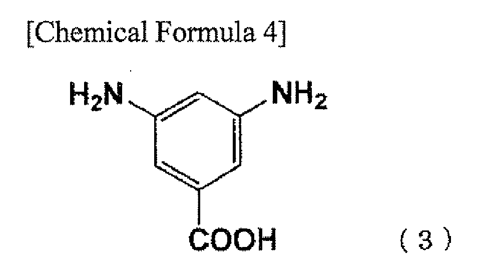

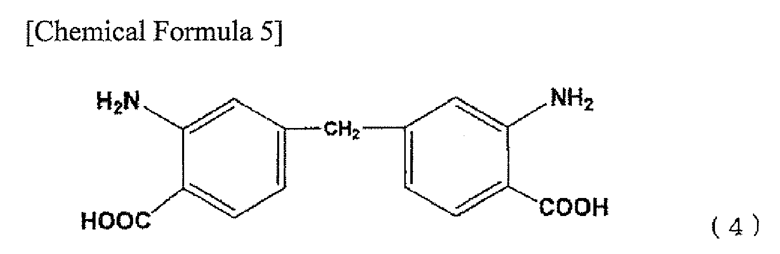

12. A film-like adhesive obtained by forming a photosensitive adhesive composition according to any one of claims 1 to 11 into a film shape.

13. An adhesive sheet comprising a base and an adhesive layer composed of an adhesive composition according to any one of claims 1 to 11 formed on one side of the base.

14. An adhesive sheet having a laminated structure obtained by laminating a film-like adhesive according to claim 12 with a dicing sheet.

15. An adhesive pattern that is formed by forming an adhesive layer composed of a photosensitive adhesive composition according to any one of claims 1 to 11 on an adherend, exposing the adhesive layer to light through a photomask, and developing the exposed adhesive layer with an alkali developing solution.

16. A semiconductor wafer with an adhesive layer, that comprises a semiconductor wafer and an adhesive layer composed of a photosensitive adhesive composition according to any one of claims 1 to 11 formed on one side of the semiconductor wafer.

17. A semiconductor device wherein a semiconductor element and a semiconductor element-mounting supporting member are bonded by a photosensitive adhesive composition according to any one of claims 1 to 11.

18. A semiconductor device manufacturing method, which comprises a step of bonding a semiconductor element and a semiconductor element-mounting supporting member by a photosensitive adhesive composition according to any one of claims 1 to 11.
